# EUROPÄISCHE PATENTSCHRIFT

(11) **EP 3 050 134 B1**
(45) Veröffentlichungstag und Bekanntmachung des Hinweises auf die Patenterteilung: **05.05.2021**
(21) Anmeldenummer: 14786142.1
(22) Anmeldetag: 26.09.2014
(51) Int. Cl.: H01L 51/30, H01L 51/42

(54) **PHOTOAKTIVES; ORGANISCHES MATERIAL FÜR OPTOELEKTRONISCHE BAUELEMENTE**
PHOTOACTIVE ORGANIC MATERIAL FOR OPTOELECTRONIC COMPONENTS
MATÉRIAU ORGANIQUE PHOTOACTIF POUR COMPOSANTS OPTOÉLECTRONIQUES

(30) Priorität: 27.09.2013 DE 102013110693
(43) Veröffentlichungstag der Anmeldung: 03.08.2016
(73) Patentinhaber: Heliatek GmbH, 01139 Dresden (DE); Universität Ulm, 89081 Ulm (DE)
(72) Erfinder: WEISS, Andre, 01139 Dresden (DE); GERDES, Olga, 89077 Ulm (DE); HILDEBRANDT, Dirk, 89077 Ulm (DE); FITZNER, Roland, 89077 Ulm (DE); MATTERSTEIG, Gunter, 89077 Ulm (DE); D'SOUZA, Daniel, 01139 Dresden (DE); PFEIFFER, Martin, 01139 Dresden (DE); BÄUERLE, Peter, 89275 Elchingen (DE); MISHRA, Amaresh, Bolangir - 767001 Odisha (IN); KAST, Hannelore, 88453 Erolzheim (DE); VOGT, Astrid, 89250 Senden (DE); WENZEL, Christoph, 89601 Schelklingen (DE); STECK, Christopher, 89134 Blaustein (DE); DUSKO, Popovic, 89160 Dornstadt (DE)
(86) Internationale Anmeldenummer: PCT/EP2014/070671
(87) Internationale Veröffentlichungsnummer: WO 2015/044377

(56) Entgegenhaltungen:
- EP-A2- 2 696 351
- EP-A2- 2 696 351
- YASSIN A ET AL: "Evaluation of bis-dicyanovinyl short-chain conjugated systems as donor materials for organic solar cells", SOLAR ENERGY MATERIALS AND SOLAR CELLS, ELSEVIER SCIENCE PUBLISHERS, AMSTERDAM, NL, Bd. 95, Nr. 2, 1. Februar 2011 (2011-02-01), Seiten 462-468, XP027576773, ISSN: 0927-0248 [gefunden am 2010-12-27]
- YASSIN A ET AL: "Evaluation of bis-dicyanovinyl short-chain conjugated systems as donor materials for organic solar cells", SOLAR ENERGY MATERIALS AND SOLAR CELLS, ELSEVIER SCIENCE PUBLISHERS, AMSTERDAM, NL, vol. 95, no. 2, 1 February 2011 (2011-02-01), pages 462-468, XP027576773, ISSN: 0927-0248 [retrieved on 2010-12-27]

## Beschreibung

Optoelektronische Bauelemente basieren auf den optischen und elektronischen Eigenschaften von Materialien und finden heute breite Anwendung im alltäglichen Leben, wie etwa Solarzellen, LED's, TFT's. Im Allgemeinen umfassen sie alle Produkte und Verfahren, die die Umwandlung von elektronisch erzeugten Daten und Energien in Lichtemission ermöglichen oder Lichtemissionen in Energien umwandeln.

Optoelektronische Bauelemente, die Lichtemission in Energien umwandeln umfassen Photodioden, die als Photovoltaikanalagen betrieben werden oder als lichtsensitive Sensoren oder Belichtungsmessern in verschiedenen Produkten wie Digitalkameras, CD-Abspielgeräte, Lichtschranken eingesetzt werden.

Optoelektronische Bauelemente aus größtenteils organischen Materialien sind für die Anwendung als LEDs (OLED) und Photovoltaikanlagen (OPV) bekannt. Die verwendeten organischen Materialien erfüllen in diesen optoelektronischen Bauelementen unterschiedliche Aufgaben wie z.B. den Ladungstransport, die Lichtemssion oder Lichtabsorption. Organische Materialien in optoelektronischen Bauelementen können dabei Polymere oder kleine Moleküle sein und in Lösung oder Emulsion durch nasschemische Prozesse wie Coaten oder Drucken oder im Vakuum durch z.B. Sublimation zu dünnen Schichten verarbeitet werden.

Eine Solarzelle wandelt Lichtenergie in elektrische Energie um. In diesem Sinne wird der Begriff "photoaktiv" als Umwandlung von Lichtenergie in elektrische Energie verstanden. Im Gegensatz zu anorganischen Solarzellen werden bei organischen Solarzellen durch das Licht nicht direkt freie Ladungsträger erzeugt, sondern es bilden sich zunächst Exzitonen, also elektrisch neutrale Anregungszustände (gebundene Elektron-Loch-Paare).

Daher spielt die rekombinationsarme Diffusion von Exzitonen an die aktive Grenzfläche eine kritische Rolle bei organischen Solarzellen. Um einen Beitrag zum Photostrom zu leisten, muss daher in einer guten organischen Solarzelle die Exzitonendiffusionslänge die typische Eindringtiefe des Lichts deutlich übersteigen, damit der überwiegende Teil des Lichts genutzt werden kann.

Falls es sich bei der Absorberschicht um eine Mischschicht handelt, so übernimmt die Aufgabe der Lichtabsorption entweder nur eine der Komponenten oder auch beide. Der Vorteil von Mischschichten ist, dass die erzeugten Exzitonen nur einen sehr kurzen Weg zurücklegen müssen bis sie an eine Domänengrenze gelangen, wo sie getrennt werden. Der Abtransport der Elektronen bzw. Löcher erfolgt getrennt in den jeweiligen Materialien. Da in der Mischschicht die Materialien überall miteinander im Kontakt sind, ist bei diesem Konzept entscheidend, dass die getrennten Ladungen eine lange Lebensdauer auf dem jeweiligen Material besitzen und von jedem Ort aus geschlossene Perkolationspfade für beide Ladungsträgersorten zum jeweiligen Kontakt hin vorhanden sind.

Ein wichtiger Faktor in der Verbesserung der oben genannten Solarzellen liegt in der Weiterentwicklung der organischen Schichten. Für die Absorberschichten, speziell auf dem Gebiet kleiner Moleküle, sind in den letzten 5 Jahren wenige neue Materialien bekannt geworden. In der WO2006092134A1 werden Verbindungen offenbart, die über einen Akzeptor-Donor-Akzeptor-Aufbau verfügen, wobei der Donorblock ein ausgedehntes π-System besitzt.

In der DE60205824T2 werden Thienothiophenderivate offenbart, die mit weiteren Aromaten ein π-System bilden und an beiden Seiten von Alkylgruppen eingerahmt sind, und deren Verwendung in organischen Halbleitern.

In der EP2400575A1 wird in einem Akzeptor-Donor-Akzeptor Oligomer eine Donor aus heterocyclsichen 5-Ringen mit einer Größe von maximal 9 konjugierten Doppelbindungen beschrieben. In der EP2483267A1 wird als Donorblock in Akzeptor-Donor-Akzeptor Oligomer eine Kombination aus annelierten aromatischen 5- oder 6-Ringzyklen und einzelnen 5- oder 6-Ringzyklen beschrieben.

In der WO2009051390 werden Thiophen basierte Akzeptor-Donator Farbstoffe für den Einsatz in farbstoffsensitiven Solarzellen offenbart.

In der WO 002008145172A1 werden neuartige Phthalocyanine zur Verwendung in Solarzellen vorgestellt.

In der US7655809B2 werden Verbindungen aus kondensierten Kohlenstoffzyklen in Reihe und deren Verwendung als organische Halbleiter offenbart.

In der WO 2006111511A1 und WO2007116001A2 werden Rylentetracarbonsäurederivate zur Verwendung als aktive Schicht in Photovoltaik offenbart.

Dagegen sind verschiedene Polymere zur Verwendung als aktive Schichten in organischer Photovoltaik bekannt, beispielweise offenbart in WO 2008088595A2, EP2072557A1 oder US20070112171A1. Diese sind im Allgemeinen nicht verdampfbar, sondern werden in flüssiger Form zu dünnen Schichten verarbeitet

A. Yassin et al. "Evaluation of bis-dicyanovinyl short-chain conjugated systems as donor materials for organic solar cells" Solar Energy Materials and Solar Cells, Bd. 95, Nr. 23-09-2010, Seiten 462-468, offenbart ein optoelektronisches Bauelement mit einer lichtempfindlichen Schicht, wobei die organische lichtempfindliche Schicht ein Dithienopyrrol-Derivat enthält.

Dokument EP 2 696 351 A2 (Veröffentlichungsdatum 12-02-2014) offenbart ein optoelektronisches Bauelement mit einer lichtempfindlichen Schicht, wobei die organische lichtempfindliche Schicht Verbindungen betrifft des Akzeptor-Donor-Akzeptor Typs mit ein vollständig anellierten Donor Mittelblock.

Der Erfindung liegt die Aufgabe zu Grunde die Nachteile des Stands der Technik zu überwinden und verbesserte photoaktive Bauelemente anzugeben.

Die Aufgabe wird gelöst durch den unabhängigen Anspruch 1. Ausgestaltungen der Erfindung sind in den Unteransprüchen zu finden.

Erfindungsgemäß wird die Aufgabe gelöst durch ein photoaktives Bauelement mit einer Elektrode und einer Gegenelektrode und mindestens einer organischen lichtempfindlichen Schicht zwischen der Elektrode und der Gegenelektrode, dadurch gekennzeichnet dass die organische lichtempfindliche Schicht eine Verbindung der allgemeinen
Formel I

EWG-Vn-D-Vo-EWG (I)

enthält, worin EWG gegenüber D elektronenziehende Eigenschaften besitzt,
V unabhängig voneinander -CR1=CR2- oder -C=C- mit R1 und R2 ausgesucht aus H, C1-C10-Alkyl, C1-C10-OAlkyl, C1-C10-SAlkyl, worin R1 und R2 einen Ring bilden können, und n und
o unabhängig voneinander 0 oder 1 sind und
D ein ausgedehnter Donorblock aus mindestens 5 annelierten heterocyclischen aromatischen 5-Ringen und/oder heterocyclischen oder homocyclischen aromatischen 6-Ringen, worin eine lineare Folge von konjugierten Doppelbindungen zwischen den beiden EWG vorhanden ist, aufgebaut ist, mit der Maßgabe, dass folgende Strukturen ausgeschlossen sind: 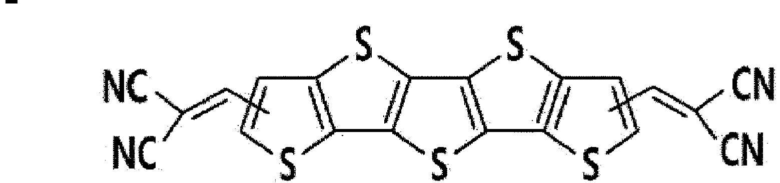 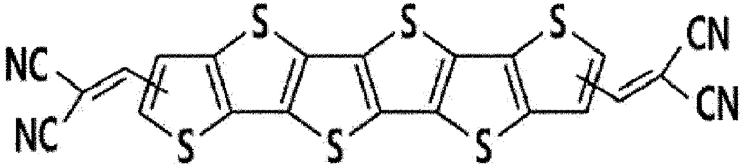 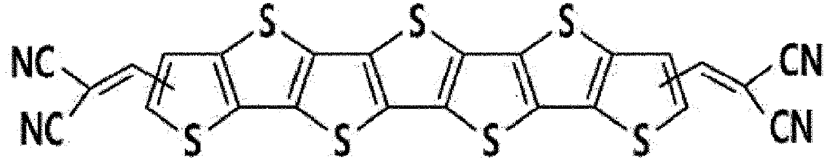 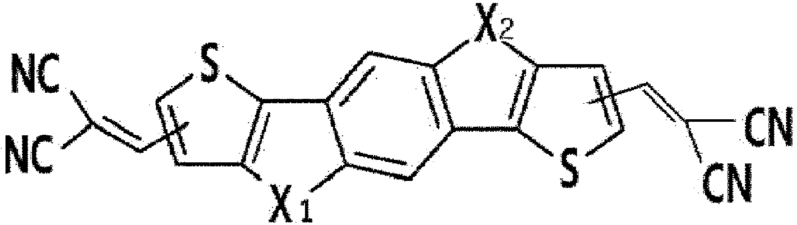 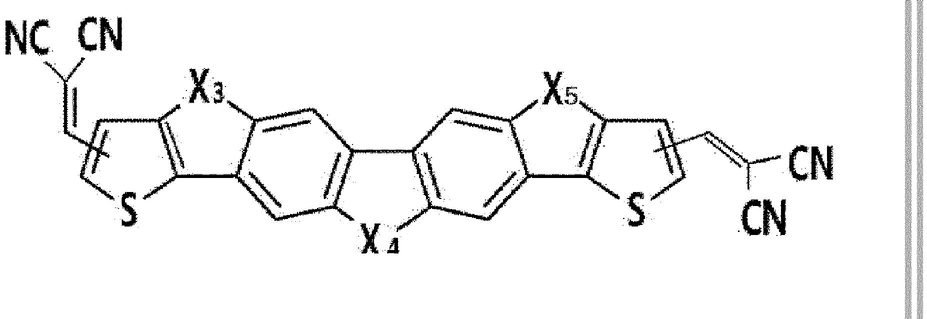 wobei X¹ bis X⁵ gleich oder verschieden sind und unabhängig voneinander CR^{1'}CR^{2'}, SiR^{3'}R^{4'}, NR^{5'}, Sauerstoff (O) oder Selen (Se) sind, wobei R^{1'} bis R^{5'} gleich oder verschieden sind und unabhängig voneinander Wasserstoff, einer substituierte oder unsubstituierte C₁ bis C₂₀ Alkylgruppe, eine substituierte oder unsubstituierte C₆ bis C₂₀ Arylgruppe, eine substituierte oder unsubstituierte C₃ bis C₂₀ Heteroarylgruppe und Kombination davon sind.

Unter "anneliert" wird in vorliegender Anmeldung verstanden, wenn 2 heterocyclische oder homocyclische aromatische Ringe sich 2 Ringatome teilen.

In einer Ausführungsform der Erfindung ist der ausgedehnte Donorblock der allgemeinen Formel I aus heterocyclischen aromatischen 5-Ringen ausgesucht aus Thiophen, Selenophen, Furan oder Pyrrol aufgebaut.

Bevorzugt ist mindestens einer der heterocyclischen aromatischen 5-Ringe des ausgedehnten Donorblocks nicht Thiophen. Besonders bevorzugt ist mindestens ein heterocyclischen aromatischen 5-Ringe des ausgedehnten Donorblocks ein Pyrrol.

In einer Ausführungsform der Erfindung ist der ausgedehnte Donorblock D der allgemeinen Formel I ausgesucht ist aus 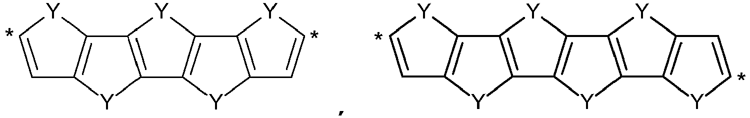 worin Y jeweils unabhängig voneinander S oder NR3 ist mit R3 ausgesucht aus C1-C10-Alkyl, C5-C10-Cycloakly, C6-C10-Aryl.

In einer Ausführungsform der Erfindung ist der ausgedehnte Donorblock D der allgemeinen Formel I aufgebaut aus maximal 7 annelierten aromatischen heterocyclischen 5-Ringen und/oder aromatischen heterocyclischen oder homocyclischen 6-Ringen.

In einer Ausführungsform der Erfindung sind in dem ausgedehnten Donorblock D der allgemeinen Formel I 1 oder 2 homocyclischen aromatische 6-Ringe. Bevorzugt sind an den homocyclischen aromatische 6-Ringe zwei O-Alkyl, die in entgegengesetzte räumliche Richtung zeigen.

In einer Ausführungsform der Erfindung ist mindestens eine dotierte Transportschicht vorhanden ist, die zwischen Elektrode oder der Gegenelektrode und der mindestens einen lichtabsorbierenden Schicht angeordnet ist.

Gegenstand der vorliegenden Erfindung ist ebenso eine Einzelzelle, eine Tandemzelle oder eine Mehrfachzelle. Unter Tandemzelle wird in vorliegender Anmeldung verstanden, dass zwei funktionale Zellen räumlich übereinander gestapelt und seriell verschaltet sind, wobei zwischen den Zellen eine Zwischenschicht angeordnet sein kann. Ebenso wird unter Mehrfachzelle verstanden, dass mehr als zwei funktionale Zellen räumlich übereinander gestapelt und seriell verschaltet sind, wobei zwischen den Zellen eine Zwischenschicht angeordnet sein kann. Bevorzugt besteht das Bauelement aus einer Kombination aus nip, ni, ip, pnip, pni, pip, nipn, nin, ipn, pnipn, pnon oder pipn-Strukturen, bie der mehrere unabhängige Kombinationen, die mindestens eine i-Schicht enthalten, übereinander gestapelt sind.

Hierbei bedeutet n bzw. p eine n- bzw. p-Dotierung, die zu einer Erhöhung der Dichte freier Elektronen bzw. Löcher im thermischen Gleichgewichtszustand führt. In diesem Sinne sind derartige Schichten primär als Transportschichten zu verstehen. Die Bezeichnung i-Schicht bezeichnet demgegenüber eine undotierte Schicht (intrinsische Schicht). Eine oder mehrere i-Schicht(en) können hierbei Schichten sowohl aus einem Material, als auch eine Mischung aus zwei oder mehr Materialien (sogenannte interpenetrierende Netzwerke) bestehen.

Gegenstand der vorliegenden Erfindung ist weiterhin eine organische Solarzelle mit einem photoaktiven Bereich, der wenigstens ein organisches Donormaterial in Kontakt mit wenigstens einem organischen Akzeptormaterial aufweist, wobei das Donormaterial und das Akzeptormaterial einen Donor-Akzeptor-Heteroübergang ausbilden und wobei der photoaktive Bereich wenigstens eine Verbindung der Formel I, wie zuvor definiert, enthält.

Gemäß einer bevorzugten Ausführungsform der vorliegenden Erfindung ist das photoaktive Bauelement ausgewählt aus einer organischen Solarzelle, einer organischen Elektrolumineszenzvorrichtung, einem Photodetektor und einem organischen Feldeffekttransistor. Insbesondere ist die Vorrichtung eine organische Solarzelle.

In einer Ausführungsform der Erfindung ist das photoaktive Bauelement eine Tandemsolarzelle mit 2 Donor-Akzeptor-Heteroübergängen, wobei mindesten ein Material des ersten Donor-Akzeptor-Heteroübergangs unterschiedlich ist zu den beiden Hauptkomponenten des zweiten DOnor-Akzeptor-Heteroübergangs.

Typische elektronenziehende Gruppen EWG sind: aus 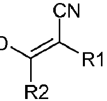 mit R1 = H, CN und R2 = H, CH³, CN, 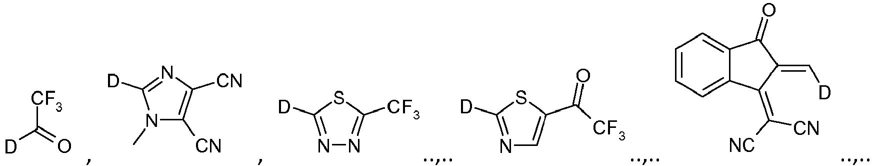 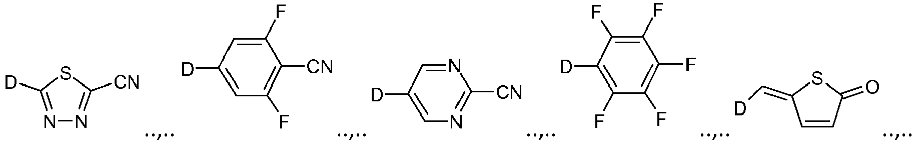 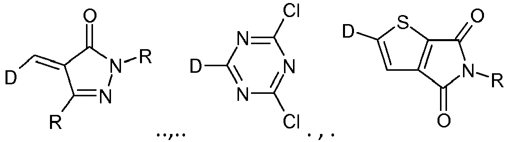 worin D die Bindungsstelle zum ausgedehnten Donorblock D darstellt und R ein Substituent ausgesucht aus verzweigtem oder geradekettigem C1-C8-Alkyl.

In einer Ausführungsform der Erfindung ist V ein Cyclohexen und m und/oder o 1. Beispielhaft wird folgende Verbindung gezeigt:

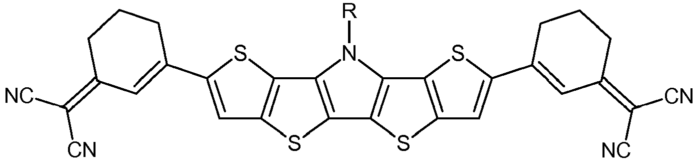

Cyclohexen als Verbindungsgruppe zwischen dem Donorblock und der elektronenziehenden Gruppen bietet den Vorteil einer einfachen cis-trans-stereomerenreinen Herstellung der Verbindungen. Dabei können am Hexen weitere Substituenten vorhanden sein.

In einer Ausführungsform der Erfindung sind n und o 0. Typische Verbindungen sind:

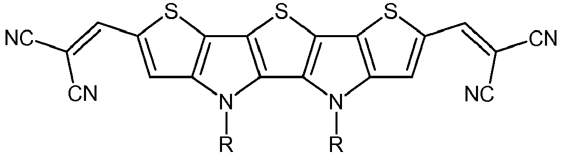

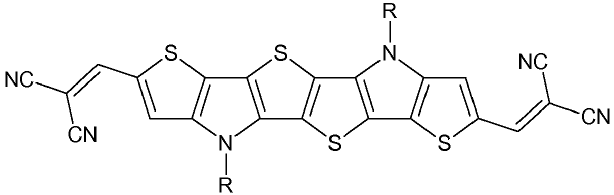

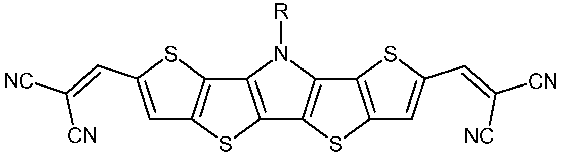

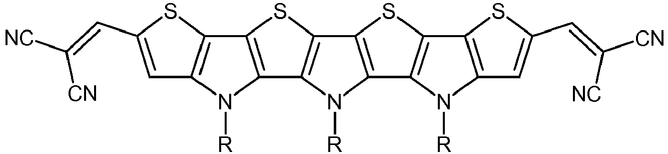

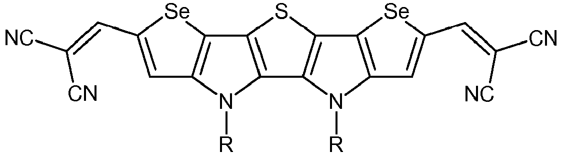

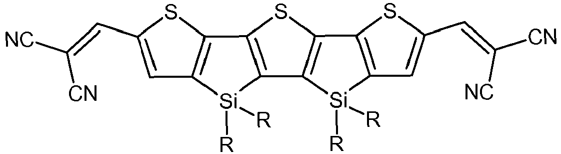

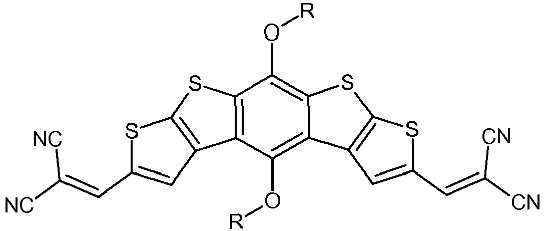

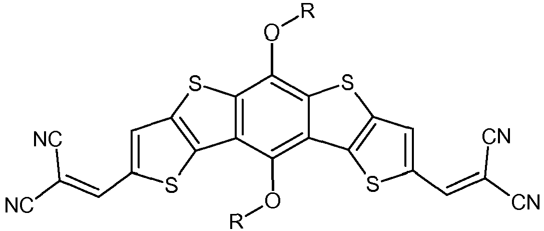

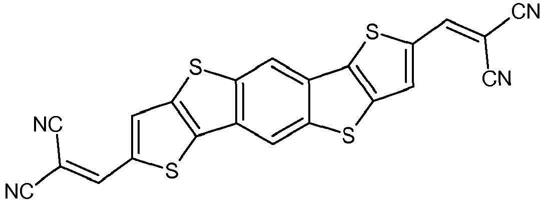

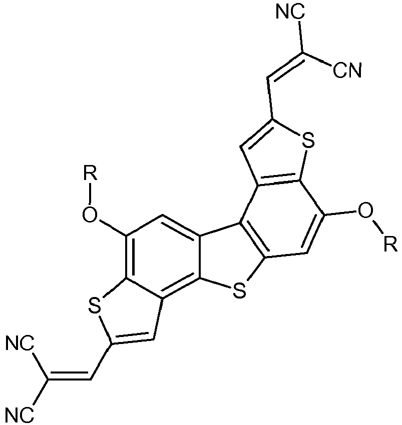

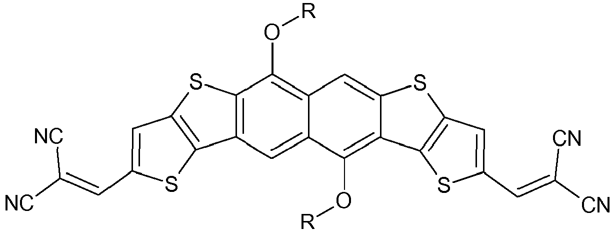

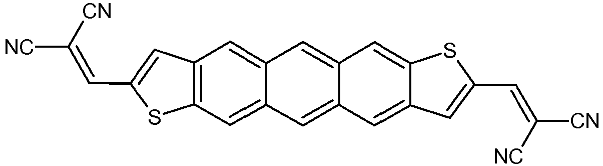

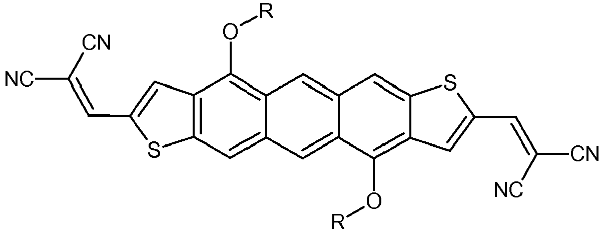

In einer Ausführungsform der Erfindung sind n und/oder o 1. Typische Verbindungen sind:

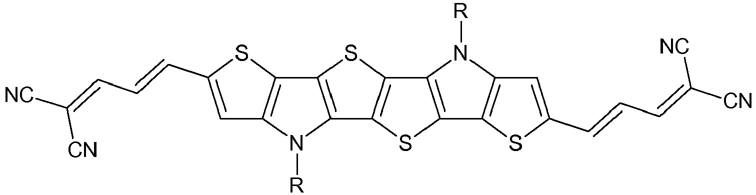

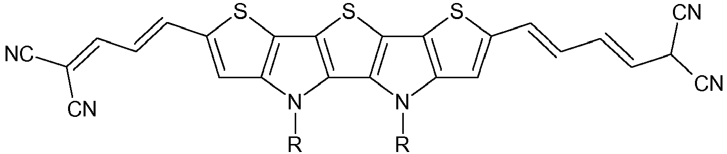

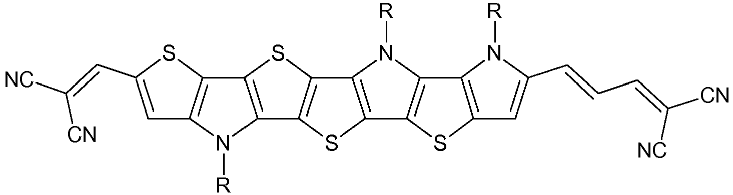

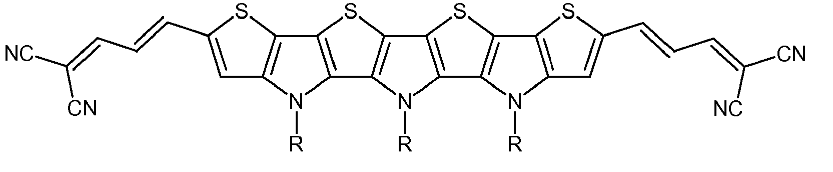

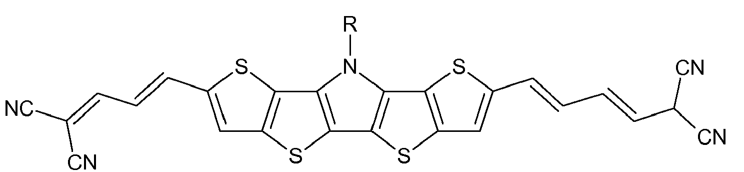

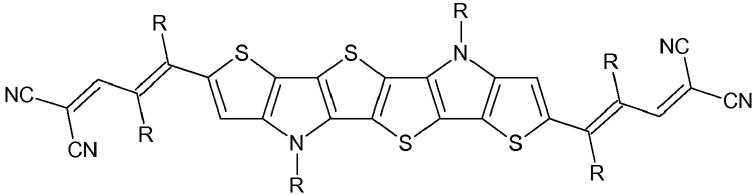

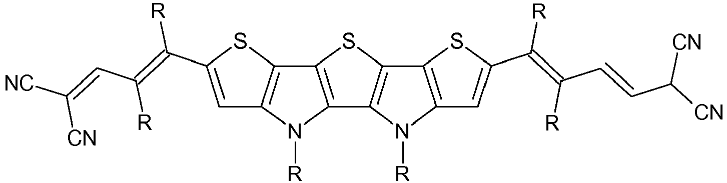

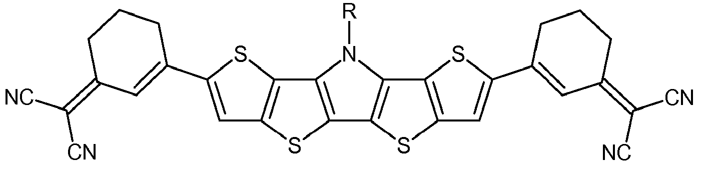

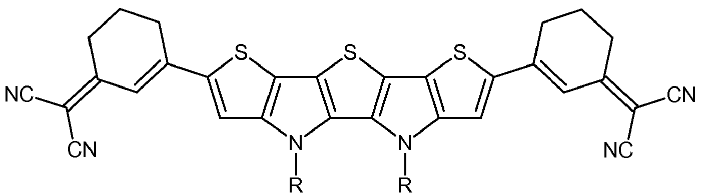

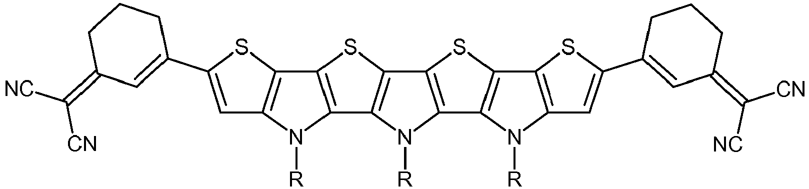

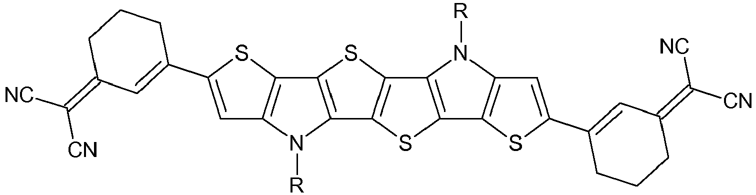

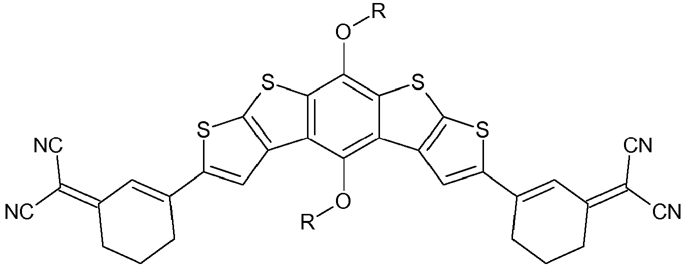

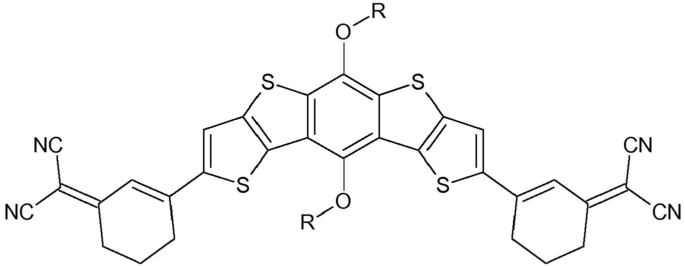

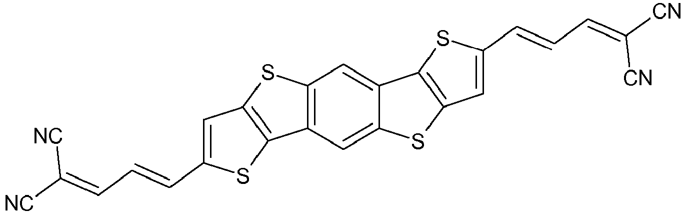

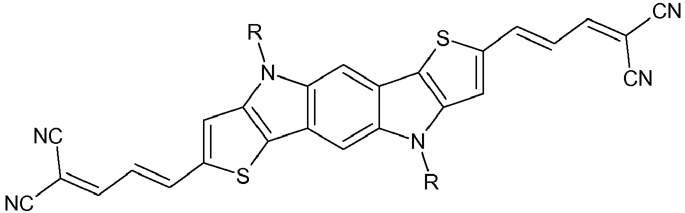

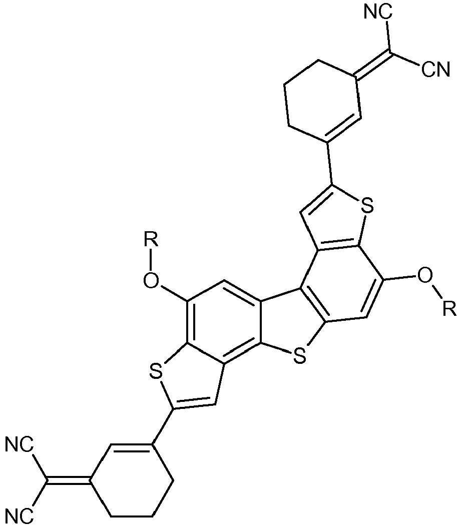

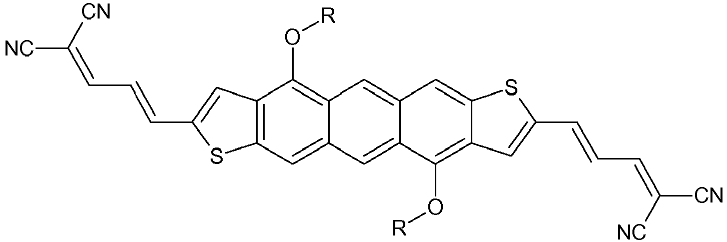

Die erfindungsgemäß eingesetzten Verbindungen der Formel I zeichnen sich durch wenigstens eine der folgenden vorteilhaften Eigenschaften aus:
Stannylfreie Syntheseverfahren
Hohe thermische Stabilität
Steile Absorptionsflanke, vor allem am längerwelligen Ende
Sehr hohe Extinktionskoeffizienten

Der Gehalt an der Verbindung der Formel I in dem photoaktiven Bereich beträgt vorzugsweise 10 bis 90 Gew.-%, besonders bevorzugt 25 bis 75 Gew.-%, bezogen auf das Gesamtgewicht des Halbleitermaterials (p- und n-Halbleiter) in dem photoaktiven Bereich.

Die Herstellung der annelierten Donorblöcke D können über eine Vielzahl in der Literatur bekannter Verfahren hergestellt werden. Dabei erfolgt vorzugsweise ein Aufbau einer Kette einzelner Heterocyclen oder annelierter kleinerer Fragmente und anschließendem Ringschluss.

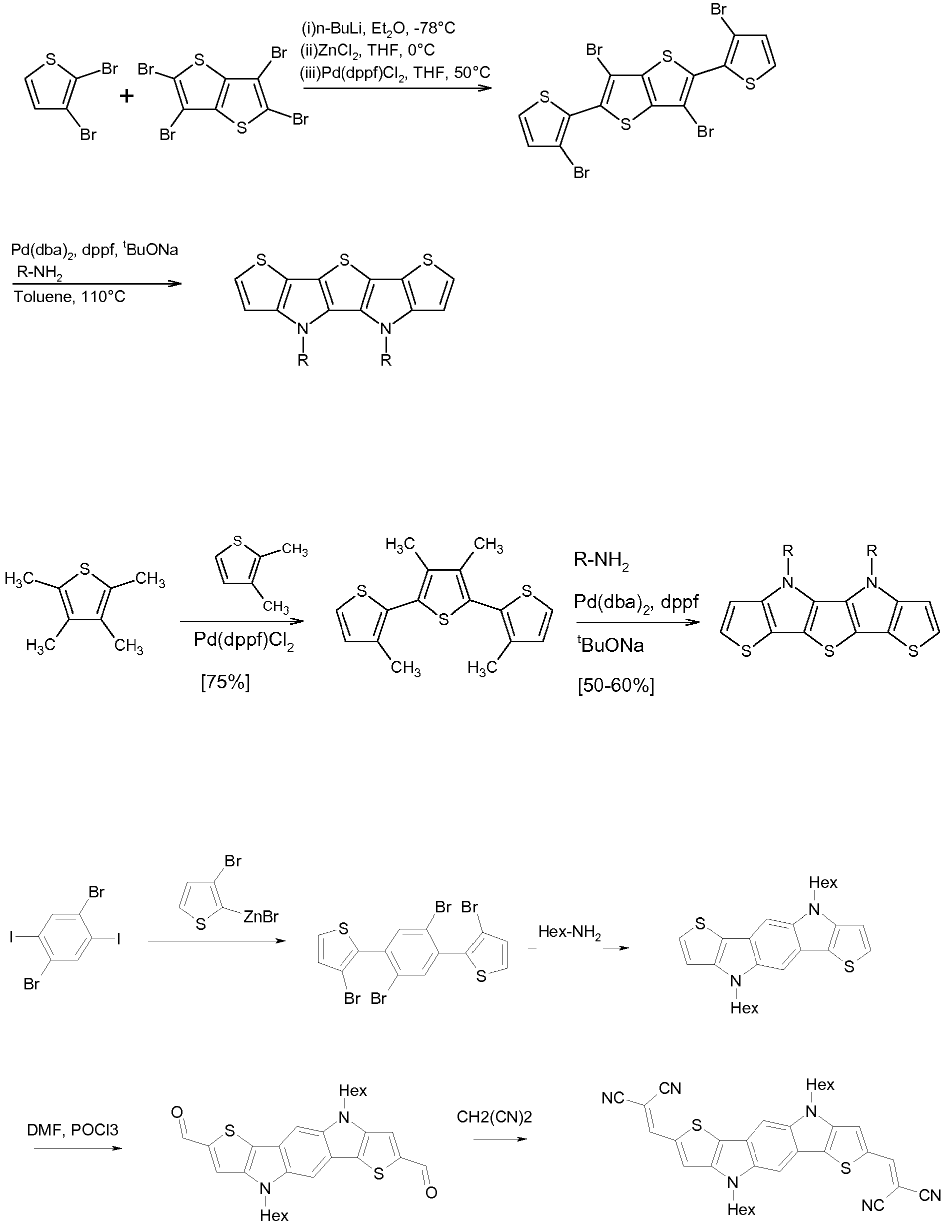

Die Einführung der endständigen Akzeptorgruppen kann beispielsweise erfolgen durch dem Fachmann bekannte Methoden, wie z.B. Gattermann, Gattermann-Koch, Houben-Hoesch, Vilsmeier/ Vilsmeier-Haack, Friedel-Crafts-Acylierung oder nach Lithiierung durch eine Umsetzung mit einem Säurederivat oder Carbonylierungsreagenz.

Weitere Akzeptorgruppen sind durch Umfunktionalisierung der zuvor beschriebenen Carbonylfunktion C(O)R beispielsweise durch Knoevenagel-Kondensation realisierbar.

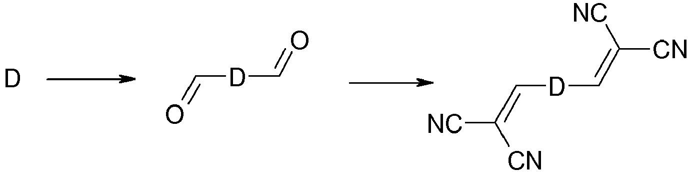

Die Einführung der Akzeptorendgruppen kann beispielsweise mit BuLi und Tetracyanoethylen erfolgen (Cai et al, J. Phys. Chem. B 2006, 110, 14590).

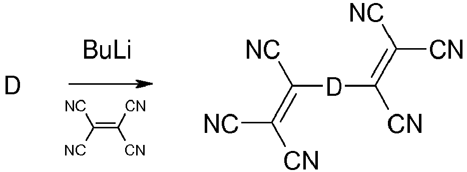

Alternativ kann die Umsetzung auch ohne BuLi in DMF durchgeführt werden (Pappenfus et al, Org. Lett. 2008, 10, 8, 1553).

Cyclohexenyl als Akzeptorendgruppe kann beispielsweise über in der Literatur bekannte Kupplungsreaktionen (z.B. Stille, Suzuki, Negishi, ...) erfolgen.

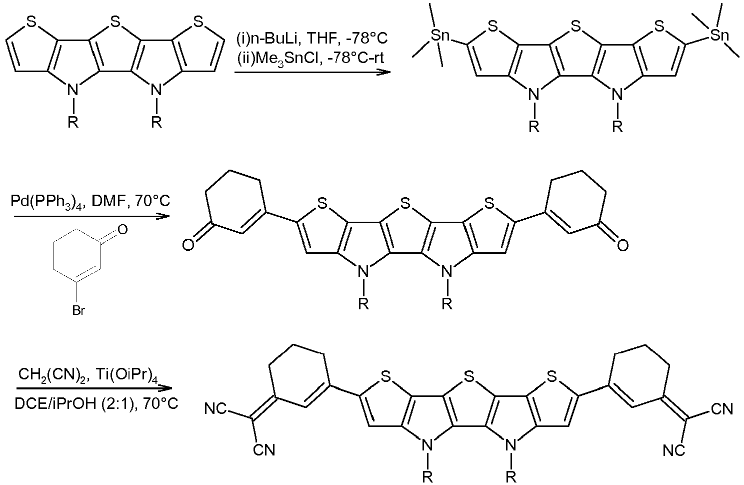

Verbindungen mit unterschiedlichen Akzeptorendgruppen lassen sich prinzipiell mit den gleichen Methoden herstellen.

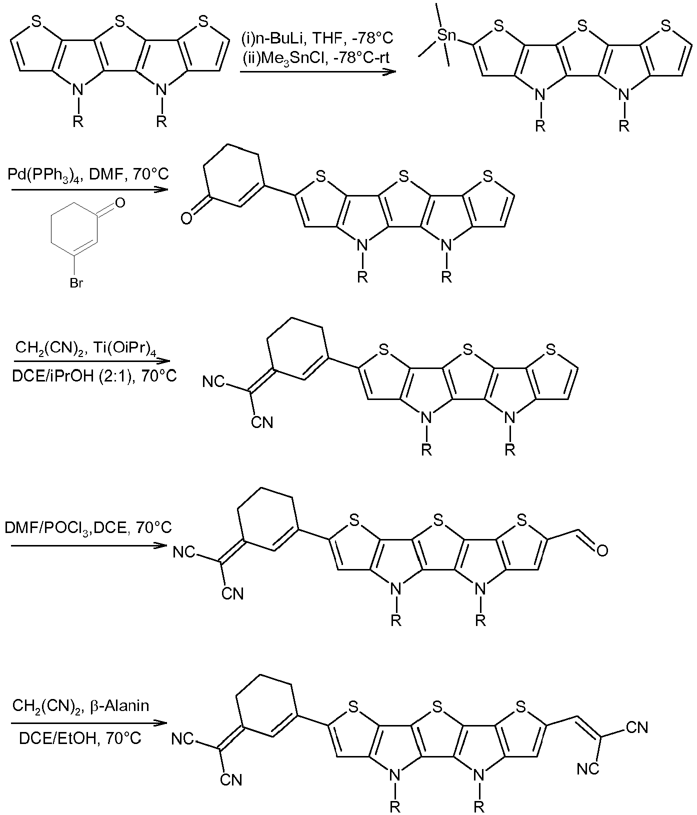

Verbindungen der Formel (I) bei denen n und/oder o gleich 1 sind lassen sich darstellen, indem D mit POCl3 und Dimethylaminoacrolein umgesetzt wird. Alterantiv kann D mit einer Base deprotoniert werden und anschließend mit Dimethylaminoacrolein umgesetzt werden (Theng et al. Chem. Mater. 2007, 19, 432-442). Der so erhaltene Vinylaldehyd kann in einer anschließenden Knoevenagel-Reaktion zu einer Dicyanovinylverbindung umgesetzt werden. 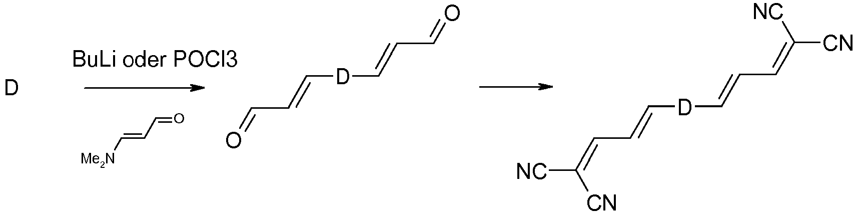 Die Reihenfolge der Reaktionen kann variiert werden.

Erstaunlicherweise wurde gefunden, dass die erfindungsgemäßen Verbindungen einen sehr hohen Extinktionswert besitzen. Dies lässt sich nicht nur mit steigender Anzahl an Mehrfachbindungen im Molekül begründen, wie die folgende Tabelle zeigt.

| Verbindung | Anzahl Mehrfachbindungen im gesamten Molekül | Extinktionskoeffizienz | Extinktionskoeffizient pro Mehrfachbindung |
|---|---|---|---|
| | | kL/molcm | kL/molcm |
| V-1 | 10 | 93,6 | 9,4 |
| 1 | 12 | 140 | 11,7 |
| 2 | 13 | 160 | 12,3 |
| 3 | 14 | 178 | 12,7 |

Dabei stellt V-1 eine nicht erfindungsgemäße Vergleichsverbindung dar und 1 bis 3 sind unterschiedliche lange erfindungsgemäße Verbindungen.

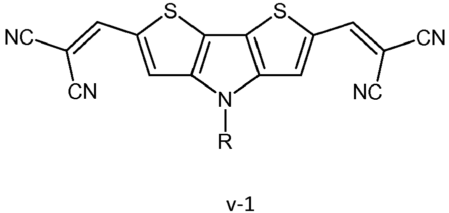

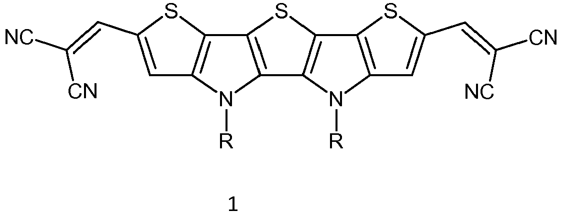

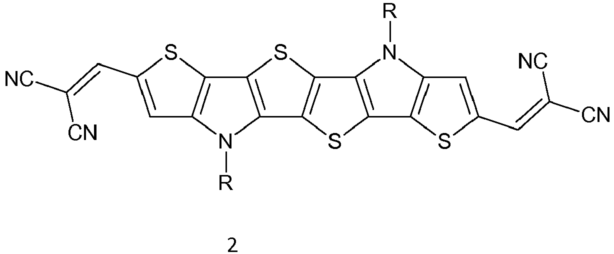

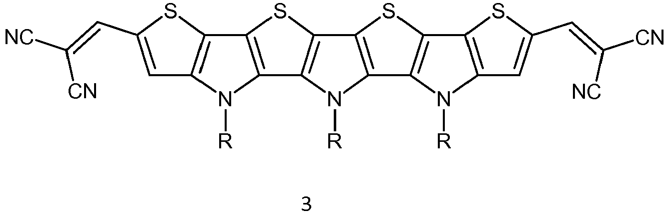

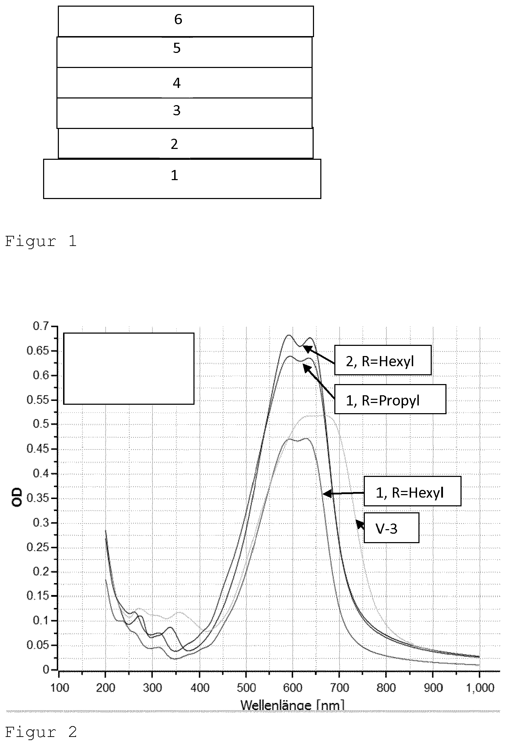

In Figur 2 ist ein Vergleich der Absorprtionspektren von erfindungsgemäßen Verbindungen 1 einmal mit R=Hexyl und einmal mit R=Propyl und 2 mit R=Hexyl im Vergleich zu nichterfindungsgemäßer Verbindung V-3 mit gleicher Anzahl an Merhfachbindungen.

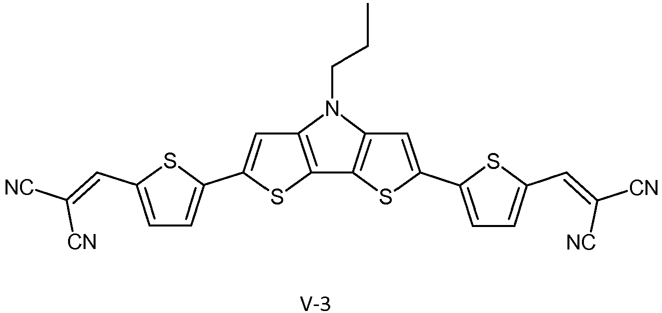

Das Absorpionsspektrum ist für die erfindungsgemäßen Verbindungen deutlich strukturierter, sowie schmaler und in den kürzerwelligen Bereich verschoben. Dies ist ein signifikanter Unterschied, der zu es ermöglicht in Kombination mit einem weiteren photoaktiven Material mit einer Absorption im längerwelligen Bereich zu einem verbesserten photoaktiven Bauelement zu kommen, z.B. in einer Tandem- oder Mehrfachzelle.

Die Herstellung eines erfindungsgemäßen photoaktiven Bauelements kann entweder ganz oder teilweise hergestellt werden durch Abscheiden im Vakuum mit oder ohne Trägergas, durch Drucken, aufschleudern, Auftropfen, Coaten oder anderen gängige Techniken zum Verarbeiten von gelösten oder suspendierten Materialien zu dünnen Schichten.

In einer Ausführungsform der Erfindung erfolgt die Herstellung der photoaktiven Donor-Heteroübergänge durch eine gasphasenabscheidung. Hiebei kann die Verbindung der allgemeinen Formel I und ein geeignetes Akzeptormaterial beispielsweise aus der Klasse der Fullerene im Sinne einer Co-Sublimation als Mischschicht abgeschieden werden oder als einzelne Schichten hintereinander als flacher Heteroübergang. Die Abscheidung erfolgt im Hochvakuum bei einem Druck im Bereich von etwa 10⁻² bis 10⁻⁸mbar. Die Abscheidungsrate liegt üblicherweise in einem Bereich von etwa 0,01 bis 10nm/s.

Die Temperatur des Substrats bei der Abscheidung liegt vorzugsweise bei 50 bis 150°C.

Geeignete Substrate für organische Solarzellen sind z. B. oxidische Materialien, Polymere und Kombinationen davon. Bevorzugte oxidische Materialien sind ausgewählt unter Glas, Keramik, SiO2, Quarz, etc. Bevorzugte Polymere sind ausgewählt unter Polyolefinen (wie Polyethylen und Polypropylen), Polyestern (wie Polyethylenterephthalat und Polyethylennaphthalat), Fluorpolymeren, Polyamiden, Polyurethanen, Polyalkyl(meth)acrylaten, Polystyrolen, Polyvinylchloriden und Mischungen und Kompositen davon.

Als Elektroden (Kathode, Anode) eignen sich prinzipiell Metalle, Halbleiter, Metalllegierungen, Halbleiterlegierungen und Kombinationen davon, sogenannte DMD's, aber auch Silber-Nanoröhrchen oder spezielle Graphite. Bevorzugte Metalle sind die der Gruppen 2, 9, 10, 11 oder 13 des Periodensystems (PES), z. B. die Erdalkalimetalle (Gruppe 2) Mg, Ca und Ba, der 10. Gruppe des PES wie Pt, der 11. Gruppe des PES wie Au, Ag und Cu und der 13. Gruppe des PES wie Al und In. Bevorzugt sind Metalllegierungen, z.B. auf Basis Pt, Au, Ag, Cu, etc. und spezielle Mg/Ag-Legierungen, des Weiteren aber auch Alkalimetallfluoride, wie LiF, NaF, KF, RbF und CsF, und Mischungen aus Alkalimetallfluoriden und Alkalimetallen.

Geeignete Akzeptormaterialien sind vorzugsweise ausgewählt aus der Gruppe Fullerene und Fullerenderivate, polycyclische aromatische Kohlenwasserstoffen und deren Derivaten, insbesondere Naphthalin und dessen Derivate, Rylene, insbesondere Perylen, Terrylen und Quaterrylen, und deren Derivate, Azene, insbesondere Anthrazen, Tetrazen, in besondere Rubren, Pentazen und deren Derivate, Pyren und dessen Derivat, Chinone, Chinondimethane und deren Derivaten, Phthalocyanine, Subphthalocyanine und deren Derivaten, Porphyrine, Tetraazoporphyrine, Tetrabenzoporphyrine und deren Derivaten, Thiophene, oligo-Thiophene, kondensierte/anellierte Thiophene, wie Thienoth ophen und Bithienothiophen, und deren Derivate, Thiadiazole und deren Derivate, Carbazole und Triarylamine und deren Derivate, Indanthrone, Violanthrone und Flavanthone und deren Derivate und Fulvalene, Tetrathiafulvalene und Tetraselenafulvalene und deren Derivate

Vorzugsweise ist das Akzeptormaterial ein oder mehrere Fullerene und/oder Fulleren-Derivate. Geeignete Fullerene sind vorzugsweise ausgewählt unter C60, C70, C76, C80, C82, C84, C86, C90 und C94. Geeignete Fullerenderivate sind vorzugsweise ausgewählt unter Phenyl-C61-Butyrsäuremethylester ([60]PCBM), Phenyl-C71-Butyrsäuremethylester ([71]PCBM), Phenyl-C84-Butyrsäuremethylester ([84]PCBM), Phenyl-C61-Butyrsäurebutylester ([60]PCBB), Phenyl-C61-Butyrsäureoctyylester ([60]PCBO) und Thienyl-C61-Butyrsäuremethylester ([60]ThCBM). Besonders bevorzugt sind C60, [60]PCBM und Mischungen davon.

Zusätzlich zu den Schichten mit Donor-Akzeptor-Heteroübergang kann das photoaktive Bauelement weitere Schichten beinhalten, die beispielsweise als Transportschichten dienen und üblicherweise das einfallende Licht nur bei einer Wellenlänge unterhalb 450nm absorbieren, so genannte wide-gap Materialien. Transportschichten lochleitende oder elektronenleitende Eigenschaften haben und undotiert oder dotiert sein.

Geeignete Schichten mit lochleitenden Eigenschaften enthalten vorzugsweise wenigstens ein Material mit einer geringen Ionisierungsenergie bezogen auf Vakuumniveau, d.h. die Schicht mit lochleitenden Eigenschaften weist eine kleinere Ionisierungsenergie und eine kleinere Elektronenaffinität, bezogen auf Vakuumniveau, auf als die Schicht mit elektronenleitenden Eigenschaften. Bei den Materialien kann es sich um organische oder anorganische Materialien handeln. Für den Einsatz in einer Schicht mit lochleitenden Eigenschaften geeignete organische Materialien sind vorzugsweise ausgewählt unter Poly(3,4-ethylendioxythiophen)-poly(styrolsulfonat) (PEDOT-PSS), Ir-DPBIC (Tris-N,N'-Diphenylbenzimidazol-2-yliden-iridium(III)), N,N'-diphenyl-N,N'-bis(3-methylphenyl)-1,1'-diphenyl-4,4'-diamin (NPD), 2,2',7,7'-Tetrakis(N,N-di-p-methoxyphenylamin)-9,9'-spirobifluoren (spiro-MeOTAD), 9, 9-Bis (4- (N, N- bis-biphenyl-4-yl-amino) phenyl) -9H-fluoren (BPAF), N,N-Diphenyl-N,N-bis (4- (N,N-bis (naphth-l-yl) - amino) -biphenyl-4-yl) -benzidin (DiNPB) etc. und Mischungen davon.

Geeignete Schichten mit elektronenleitenden Eigenschaften enthalten vorzugsweise wenigstens ein Material, dessen LUMO, bezogen auf Vakuumniveau, energetisch höher liegt als das LUMO des Materials mit lochleitenden Eigenschaften. Bei den Materialien kann es sich um organische oder anorganische Materialien handeln. Für den Einsatz in einer Schicht mit elektronenleitenden Eigenschaften geeignete organische Materialien sind vorzugsweise ausgewählt unter Fullerenen und Fullerenderivaten wie zuvor definiert, 2,9-Dimethyl-4,7-diphenyl-1,10-phenanthrolin (BCP), 4,7-Diphenyl-1,10-phenanthrolin (Bphen), 1,3-bis[2-(2,2'-bipyridin-6-yl)-1,3,4-oxadiazo-5-yl]benzol (BPY-OXD), etc. Geeignete Fullerene und Fullerenderivate sind vorzugsweise ausgewählt unter C60, C70, C84, Phenyl-C61-Butyrsäuremethylester ([60]PCBM), Phenyl-C71-Butyrsäuremethylester ([71]PCBM), Phenyl-C84-Butyrsäuremethylester ([84]PCBM), Phenyl-C61-Butyrsäurebutylester ([60]PCBB), Phenyl-C61-Butyrsäureoctyylester ([60]PCBO), Thienyl-C61-Butyrsäuremethylester ([60]ThCBM) und Mischungen davon. Besonders bevorzugt sind C60, [60]PCBM und Mischungen davon. Ganz besonders bevorzugt enthält die Schicht mit elektronenleitenden Eigenschaften C60.

In einer weiteren Ausführungsform enthält das p-Transportschichtsystem einen p-Dotanden, wobei dieser p-Dotand F4-TCNQ, ein p-Dotand wie in DE10338406, DE10347856, DE10357044, DE102004010954, DE102006053320, DE102006054524 und DE102008051737 beschrieben oder ein Übergangsmetalloxid (VO, WO, MoO, etc.) ist.

In einer weiteren Ausführungsform enthält das n-Transportschichtsystem einen n-Dotanden, wobei dieser n-Dotand ein TTF-Derivat (Tetrathiafulvalen-Derivat) oder DTT-Derivat (Dithienothiophen), ein n-Dotand wie in DE10338406, DE10347856, DE10357044, DE102004010954, DE102006053320, DE102006054524 und DE102008051737 beschrieben oder Cs, Li oder Mg ist.

Die Erfindung soll an einigen nachfolgenden Ausführungsbeispielen und dazu gehöriger Figuren näher erläutert werden, ohne sich auf diese zu beschränken.

Es zeigen die
Figur 1 ein erfindungsgemäßes Bauelement. Dabei stellt 1 das Substrat dar, 2 ein optionales Transportschichtsystem aus einem oder mehreren Schichten, 3 ein photoaktiver Schichtstapel mit mindestens einer erfindungsgemäßen Verbindung, 5 ein weiteres optionales Transportschichtsystem aus einem oder mehreren Schichten und 6 eine Gegenelektrode,
Figur 2 ein Vergleich von Absoprtionsspektren im Film von 3 erfindungsgemäßen Verbindungen mit einer nichterfindungsgemäßen Verbindung,
Figur 3 eine Strom-Spannungs-Kurve eines erfindungsgemäßen Bauelements mit Verbindung 1a,
Figur 4 eine Strom-Spannungs-Kurve eines erfindungsgemäßen Bauelements mit Verbindung 13 und
Figur 5 eine Strom-Spannungs-Kurve eines erfindungsgemäßen Bauelements mit Verbindung 2a.

### Ausführungsbeispiel 1

### Herstellung von Verbindung 13:

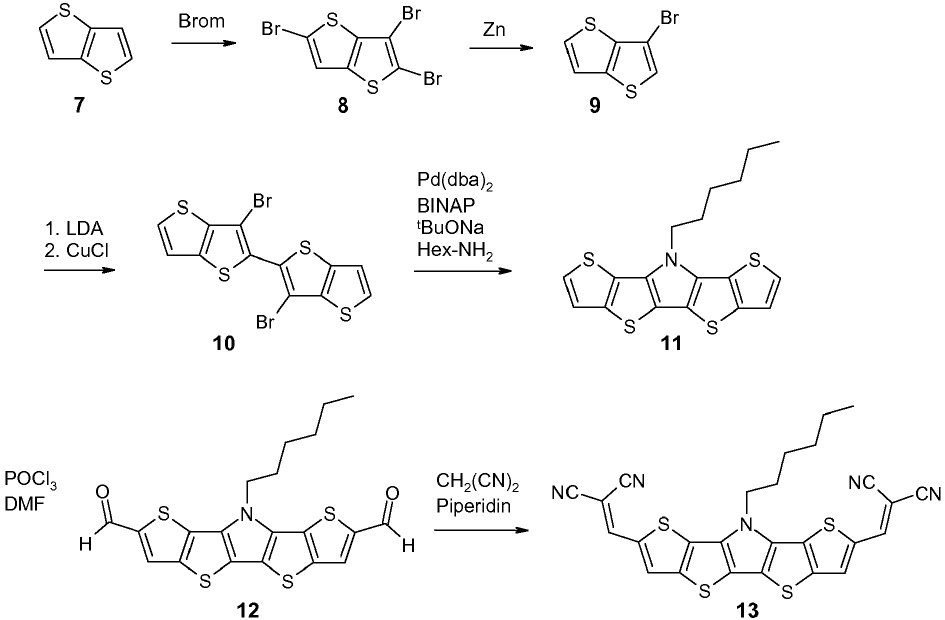

### Tribromid von Thienothiophen 8:

10,71 mmol Thienothiophen **7** werden in 30 ml Chloroform gelöst und man tropft unter Eiskühlung langsam 32,14 mmol Brom in 20 ml Chloroform hinzu. Die Reaktionsmischung wird 16 h bei Raumtemperatur gerührt. Es wird mit konz. NaOH-Lösung hydrolisiert und der Niederschlag wird in Chloroform gelöst. Man trennt die organische Phase ab und wäscht sie mit Wasser und ges. NaCl-Lösung. Die organische Phase wird über Natriumsulfat getrocknet und filtriert. Das Lösemittel wird abdestilliert und der Rückstand wird aus einer Mischung von n-Hexan und Chloroform umkristallisiert. Man erhält 9,42 mmol (88%) Produkt 8 als farblosen Feststoff. GC-MS: *m*/*z* 378 (100%) (M⁺).

### Monobromid von Thienothiophen 9:

5,5 mmol Tribromthienothiophen **8** werden in 25 ml heißer Essigsäure gelöst. Man gibt vorsichtig, portionsweise 28,0 mmol Zinkstaub hinzu und erhitzt 1h unter Rückfluß. Nach dem Abkühlen auf Raumtemperatur gibt man 100 ml Wasser hinzu und extrahiert die wässrige Phase dreimal mit Diethylether. Die vereinigten organischen Phasen werden mit ges. Natriumcarbonat-Lösung so lange gewaschen bis die wässrige Phase neutral ist. Die organische Phase wird über Natriumcarbonat getrocknet und filtriert. Das Lösemittel wird abdestilliert und der Rückstand wird chromatographisch gereinigt (SiO₂, n-Hexan, R*_{f}* = 0,50). Man erhält 4,1 mmol (74%) Produkt **9** als farblosen Feststoff. GC-MS: *m*/*z* 220 (100%) (M⁺).

### Thienothiophen-Dimer 10:

6,76 mmol Monobromthienothiophen **9** werden in 10 ml trockenem THF gelöst und auf -70°C gekühlt. Man gibt 4,13 ml einer 1,8 M LDA-Lösung hinzu und rührt 30 min bei -70°C. Die Reaktionsmischung wird auf -30°C erwärmt und 14,88 mmol CuCl₂ werden hinzugegeben. Man rührt für 1h bei -30°C und lässt anschließend über Nacht die Reaktionsmischung auf Raumtemperatur sich erwärmen. Es wird mit 2N HCL-Lösung versetzt und mit Dichlormethan (DCM) extrahiert. Die organische Phase wird mit Wasser und NaCl-Lösung gewaschen und über Natriumsulfat getrocknet. Es wird filtriert und die Lösemittel werden abdestilliert. Der Rückstand wird im Hochvakuum bei 180°C sublimiert. Das Sublimat wird aus Chloroform / n-Hexan umkristallisiert und man erhält 1,40 mmol (41%) Produkt **10** als leicht gelben Feststoff. GC-MS: *m*/*z* 436 (100%) (M⁺).

### Bis-thienothiophen-pyrrol 11:

0,69 mmol Thienothiophen-Dimer **10** werden in 5 ml Toluol gelöst. Man gibt 0,28 mmol BINAP und 1,66 mmol NaO^{t}Bu hinzu und rührt 30 min unter Argonatmosphäre. Es werden 0,14 mmol Pd(dba)₂ und 0,79 mmol Hexylamin hinzugegeben und man erhitzt das Reaktionsgemisch für 3 Tage bei 110°C. Das Reaktionsgemisch wird über eine kurze Kieselgelsäule filtriert (Eluent: DCM / n-Hexan (1:1)). Die Lösemittel des Filtrates werden abdestilliert und der Rückstand wird chromatographisch gereinigt (SiO₂, DCM / n-Hexan (1:4), R*_{f}* = 0,55). Man erhält 0,21 mmol (30%) Produkt **11** als gelben Feststoff. GC-MS: *m*/*z* 375 (100%) (M⁺).

### Dialdehyd 12:

3,31 mmol POCl₃ und 3,41 mmol DMF werden in 6 ml 1,2-Dichlorethan (DCE) gelöst und 2h bei Raumtemperatur gerührt. Diese Lösung gibt man zu einer Lösung von 0,41 mmol Bis-thienothiophen-pyrrol **11** in 10 ml DCE und rührt 40h bei 80°C. Man gibt die sich gebildete Suspension in 1N NaOH-Lösung und fügt DCM und Methanol hinzu bis der Feststoff gelöst ist. Man rührt diese Mischung 1h bei Raumtemperatur und gibt dann 20 ml ges. Natriumcarbonat-Lösung hinzu. Es wird für weitere 1,5h bei Raumtemperatur gerührt und anschließend die Phasen getrennt. Die Wässrige Phase wird dreimal mit DCM extrahiert und mit der organischen Phase vereinigt. Die organische Phase wird über Natriumsulfat getrocknet und filtriert. Die Lösemittel werden abdestilliert und der Rückstand wird chromatographisch gereinigt (SiO₂, DCM / Aceton (80:1), R*_{f}* (DCM) = 0,64). Man erhält 0,30 mmol (74%) Produkt **12** als roten Feststoff. ¹H-NMR (CDCl₃) : 9.96 ppm (s, 2H), 7.97 (s, 2H), 4.40 (dd, 2H), 1.99 (m, 2H), 1.44 (m, 2H), 1.30 (m, 4H), 0.85 (t, 3H).

### Dicyanovinyl-Verbindung 13:

0,30 mmol Dialdehyd **12** und 2,41 mmol Malodinitril werden in 40 ml DCE gelöst. Man gibt 0,03 mmol Piperidin hinzu und erhitzt 24h unter Rückfluß. Das Lösemittel wird abdestilliert und der Rückstand wird mit 20 ml Wasser für 2h unter Rückfluß erhitzt. Es wird filtriert und mit heißem Methanol gewaschen. Der Rückstand wird getrocknet und mittels Soxhletextraktor aus Chlorbenzol umkristallisiert. Man erhält 0,12 mmol (39%) Produkt **13** als schwarzen Feststoff. ¹H-NMR (TCE-d2, 375 K): 8.07 ppm (s, 2H), 7.84 (s, 2H), 4.53 (dd, 2H), 2.12 (m, 2H), 1.56-1.40 (m, 6H), 0.95 (t, 3H).

### Herstellung von Verbindung 2:

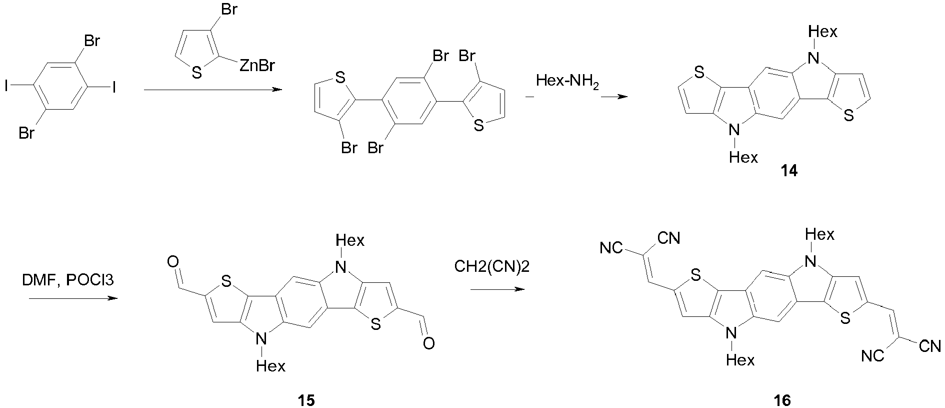

Verbindung 14 wurde, wie in der Literatur beschrieben (Donaghey, Jenny E. et al, Journal of Materials Chemistry, 21(46), 18744-18752; 2011) hergestellt.

### Dialdehyd 15:

4,84 mmol POCl₃ und 4,99 mmol DMF werden in 9 ml 1,2-Dichlorethan (DCE) gelöst und 2h bei Raumtemperatur gerührt. Diese Lösung gibt man zu einer Lösung von 0,6 mmol Bisthienopyrrolo-indol **14** in 15 ml DCE und rührt 40h bei 80°C. Man gibt die sich gebildete Suspension in 1N NaOH-Lösung und fügt DCM und Methanol hinzu bis der Feststoff gelöst ist. Man rührt diese Mischung 1h bei Raumtemperatur und gibt dann 20 ml ges. Natriumcarbonat-Lösung hinzu. Es wird für weitere 1,5h bei Raumtemperatur gerührt und anschließend die Phasen getrennt. Die Wässrige Phase wird dreimal mit DCM extrahiert und mit der organischen Phase vereinigt. Die organische Phase wird über Natriumsulfat getrocknet und filtriert. Die Lösemittel werden abdestilliert und der Rückstand wird chromatographisch gereinigt (SiO₂, DCM, R*_{f}* (DCM) = 0,39) . Man erhält 0,24 mmol (43%) Produkt **15** als roten Feststoff. Dicyanovinyl-Verbindung **16:**

0,24 mmol Dialdehyd **15** und 1,95 mmol Malodinitril werden in 5 ml DCE gelöst. Man gibt 0,03 mmol Piperidin hinzu und erhitzt 24h unter Rückfluß. Das Lösemittel wird abdestilliert und der Rückstand wird mit 20 ml Wasser für 2h unter Rückfluß erhitzt. Es wird filtriert und mit heißem Methanol gewaschen. Der Rückstand wird getrocknet und mittels Soxhletextraktor aus Toluol umkristallisiert. Man erhält 0,04 mmol (17%) Produkt **16** als schwarzen Feststoff. MALDI m/z, 588,4 [M].

### Ausführungsbeispiel 3:

### Bauelement mit Verbindung 1a

In einem weiteren Ausführungsbeispiel wird ein MIP-Bauelement auf eine Probe aus Glas mit transparentem Deckkontakt ITO hergestellt durch zeitlich nacheinander Abscheiden der folgenden Schichtfolge im Vakuum: 15nm C60, 20nm einer 1:1 Mischung durch Co-Verdampfen von Verbindung 1a und C60, wobei das Substrat auf 90°C erhitzt wird, 10nm BPAPF, 45nm p-dotiertes BPAPF und einer Gegenelektrode aus Gold.

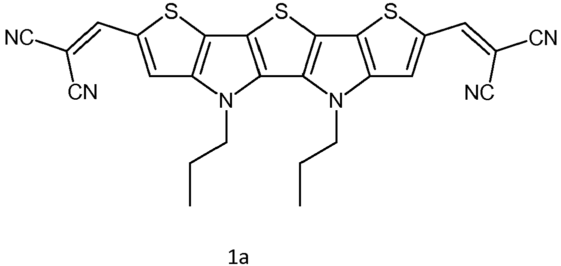

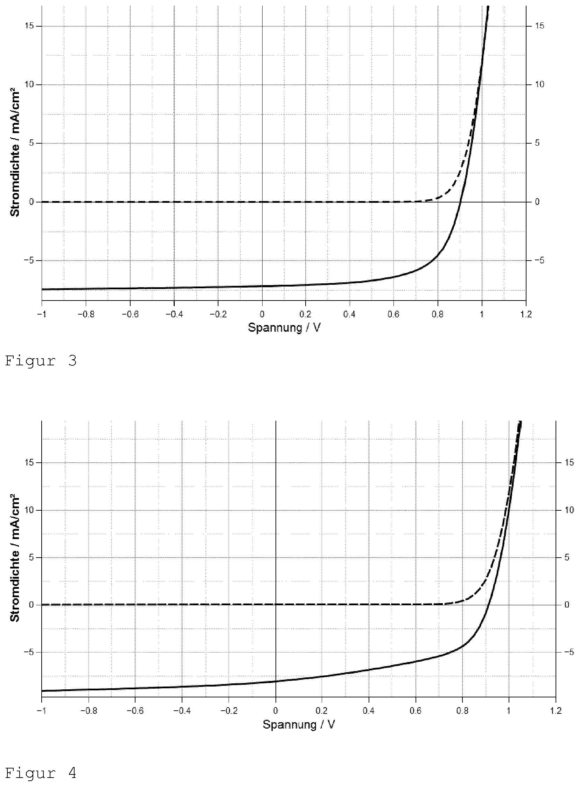

Figur 3 zeigt die Strom-Spannungs-Kurve des MIP-Bauelements mit Verbindung 1a. Dabei zeigt die gestrichelte Linie den Verlauf der Stromdichte gegen die Spannung ohne Licht und die durchgezogene Linie unter Belichtung dar. Die wichtigsten Kenngrößen zur Beurteilung des MIP-Bauelements zeigen mit dem Füllfaktor von 63,2%, dem Kurzschlussstrom von 7,2 mA/cm² und der Leerlaufspannung von 0,9V eine gut funktionierende Solarzelle an.

### Ausführungsbeispiel 4:

### Bauelement mit Verbindung 13

In einem weiteren Ausführungsbeispiel wird ein MIP-Bauelement auf eine Probe aus Glas mit transparentem Deckkontakt ITO hergestellt durch zeitlich nacheinander Abscheiden der folgenden Schichtfolge im Vakuum: 15nm C60, 20nm einer 1:1 Mischung durch Co-Verdampfen von Verbindung 13 und C60, wobei das Substrat auf 90°C erhitzt wird, 5nm BPAPF, 50nm p-dotiertes BPAPF und einer Gegenelektrode aus Gold.

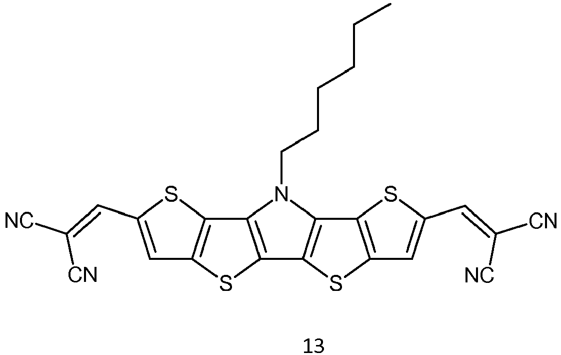

Figur 4 zeigt die Strom-Spannungs-Kurve des MIP-Bauelements mit Verbindung 13. Dabei zeigt die gestrichelte Linie den Verlauf der Stromdichte gegen die Spannung ohne Licht und die durchgezogene Linie unter Belichtung dar. Die wichtigsten Kenngrößen zur Beurteilung des MIP-Bauelements zeigen mit dem Füllfaktor von 51,6%, dem Kurzschlussstrom von 8,1 mA/cm² und der Leerlaufspannung von 0,9V eine gut funktionierende Solarzelle an.

### Ausführungsbeispiel 5:

### Bauelement mit Verbindung 2a

In einem weiteren Ausführungsbeispiel wird ein MIP-Bauelement auf eine Probe aus Glas mit transparentem Deckkontakt ITO hergestellt durch zeitlich nacheinander Abscheiden der folgenden Schichtfolge im Vakuum: 15nm C60, 20nm einer 2:1 Mischung durch Co-Verdampfen von Verbindung 1a und C60, wobei das Substrat auf 90°C erhitzt wird, 10nm BPAPF, 45nm p-dotiertes BPAPF und einer Gegenelektrode aus Gold.

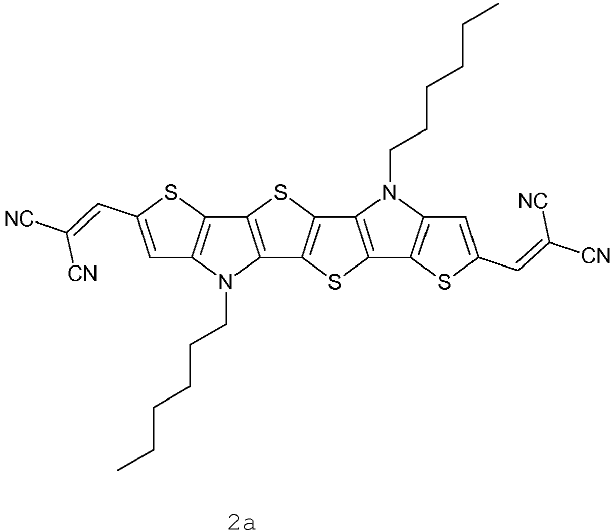

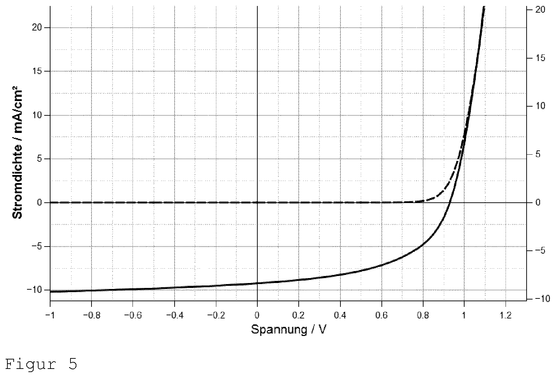

Figur 5 zeigt die Strom-Spannungs-Kurve des MIP-Bauelements mit Verbindung 2a. Dabei zeigt die gestrichelte Linie den Verlauf der Stromdichte gegen die Spannung ohne Licht und die durchgezogene Linie unter Belichtung dar. Die wichtigsten Kenngrößen zur Beurteilung des MIP-Bauelements zeigen mit dem Füllfaktor von 51,4%, dem Kurzschlussstrom von 9,3 mA/cm² und der Leerlaufspannung von 0,9V eine gut funktionierende Solarzelle an.

### Bezugszeichenliste

1 Substrat
2 Elektrode
3 Transportschichtsystem (ETL bzw. HTL)
4 photoaktiver Schichtstapel
5 Transportschichtsystem (ETL bzw. HTL)
6 Gegenelektrode

## Patentansprüche

1. Optoelektronisches Bauelement mit einer Elektrode (2) und einer Gegenelektrode (6) und mindestens einer organischen lichtempfindlichen Schicht (4) zwischen der Elektrode (2) und der Gegenelektrode (6), **dadurch gekennzeichnet dass** die organische lichtempfindliche Schicht (4) eine Verbindung der allgemeinen Formel I
EWG-Vₙ-D-Vₒ-EWG (I)
enthält, worin
EWG gegenüber D elektronenziehende Eigenschaften besitzt,
V -CR1=CR2- oder -C≡C- mit R1 und R2 ausgesucht aus H, C1-C10-Alkyl, C1-C10-OAlkyl, C1-C10-SAlkyl, worin R1 und R2 einen Ring bilden können, und n und o unabhängig voneinander 0 oder 1 sind und **dadurch gekennzeichnet, dass**
D ein ausgedehnter Donorblock aus mindestens fünf annelierten, aromatischen heterocyclischen 5-Ringen und/oder heterocyclischen oder homocyclichen 6-Ringen aufgebaut ist, mit der Maßgabe, dass folgende Strukturen ausgeschlossen sind: 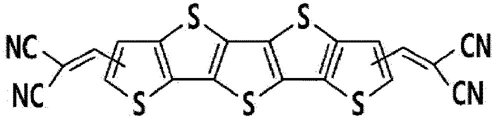 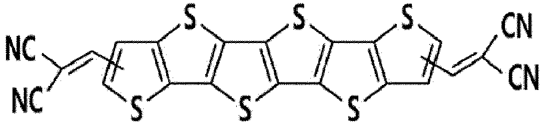 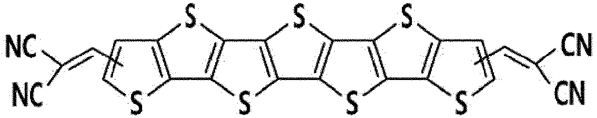 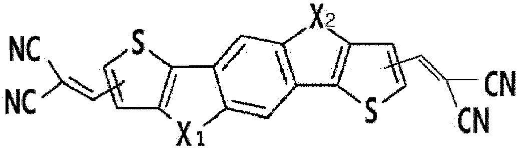 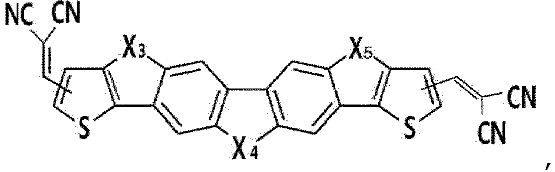 wobei X¹ bis X⁵ gleich oder verschieden sind und unabhängig voneinander CR¹'CR²', SiR³'R⁴', NR⁵', Sauerstoff (O) oder Selen (Se) sind, wobei R¹' bis R⁵' gleich oder verschieden sind und unabhängig voneinander Wasserstoff, eine substituierte oder unsubstituierte C₁ bis C₂₀ Alkylgruppe, eine substituierte oder unsubstituierte C₆ bis C₂₀ Arylgruppe, eine substituierte oder unsubstituierte C₃ bis C₂₀ Heteroarylgruppe und Kombinationen davon sind.

2. Bauelement nach Anspruch 1, **dadurch gekennzeichnet, dass** der ausgedehnte Donorblock der allgemeinen Formel I aus heterocyclischen aromatischen 5-Ringen ausgesucht aus Thiophen, Selenophen, Furan oder Pyrrol aufgebaut ist.

3. Bauelement nach Anspruch 2, **dadurch gekennzeichnet, dass** mindestens einer der heterocyclischen aromatischen 5-Ringe ausgesucht aus Selenophen, Furan oder Pyrrol ist.

4. Bauelement nach einem der Ansprüche 1 bis 3, **dadurch gekennzeichnet, dass** der ausgedehnte Donorblock D der allgemeinen Formel I ausgesucht aus 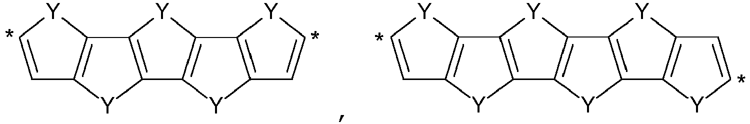 ist, worin Y jeweils unabhängig voneinander S oder NR3 ist, mit R3 ausgesucht aus C1-C10-Alkyl, C5-C10-Cycloakly, C6-C10-Aryl.

5. Bauelement nach einem der Anspruch 1, **dadurch gekennzeichnet, dass** der ausgedehnte Donorblock D maximal aus sieben annelierten aromatischen heterocyclischen 5-Ringen und/oder aromatischen heterocyclischen oder homocyclischen 6-Ringen aufgebaut ist.

6. Bauelement nach Anspruch 1, **dadurch gekennzeichnet, dass** der ausgedehnten Donorblock D der allgemeinen Formel I einen oder zwei homocyclischen aromatische 6-Ringe umfasst.

7. Bauelement nach einem der Ansprüche 1 bis 6, **dadurch gekennzeichnet, dass** n und/oder o 1 ist.

8. Bauelement nach einem der Ansprüche 1 bis 4, wobei die Verbindung der organischen lichtempfindlichen Schicht aus der Gruppe der folgenden Verbindungen ausgewählt ist:

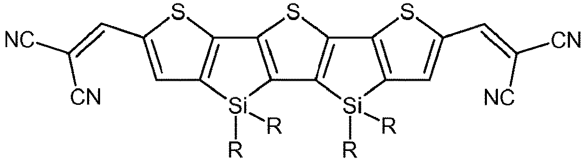

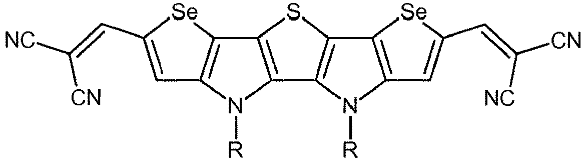

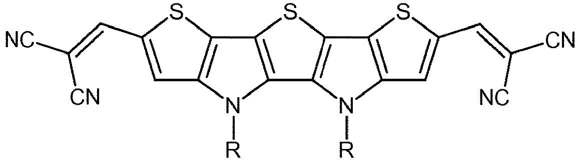

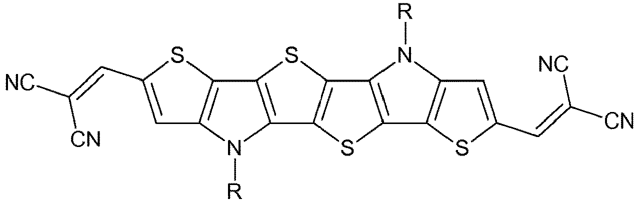

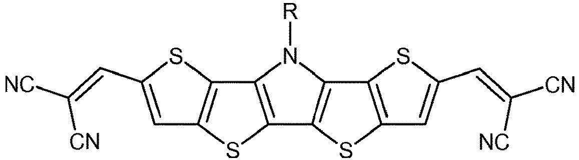

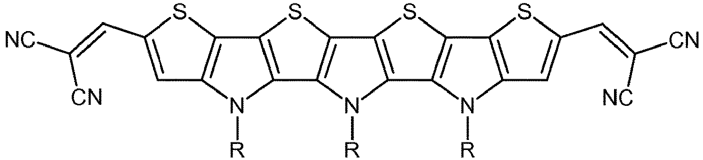

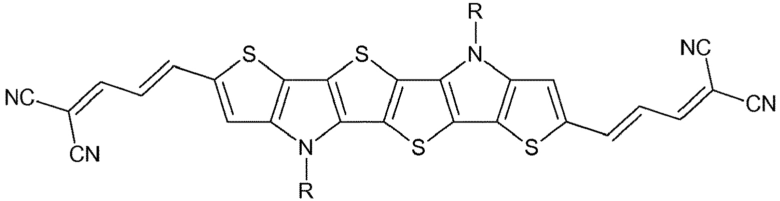

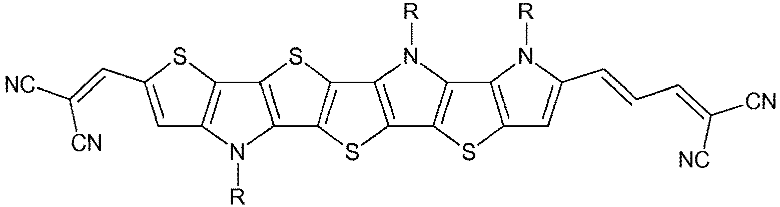

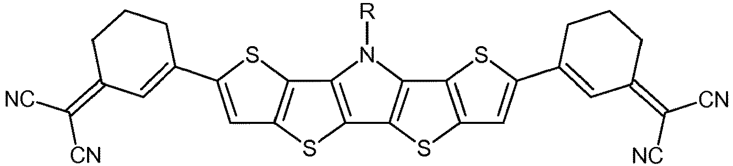

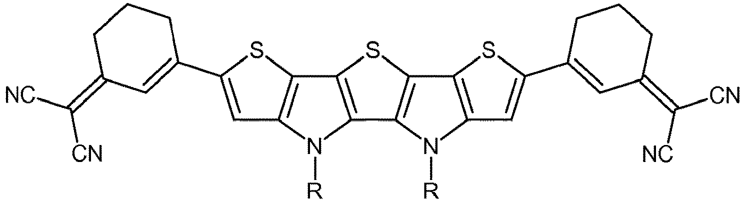

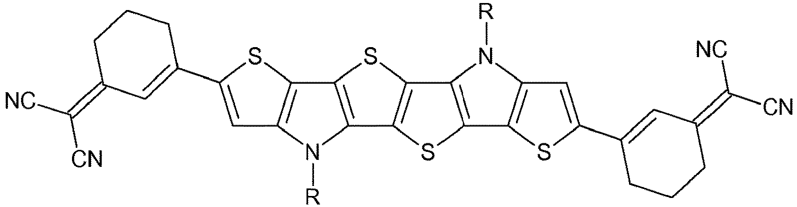

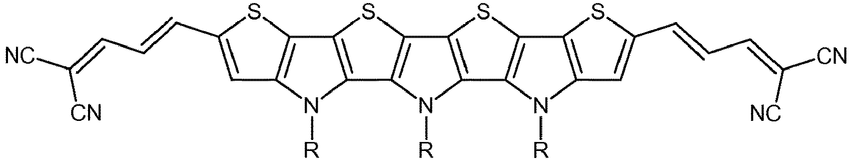

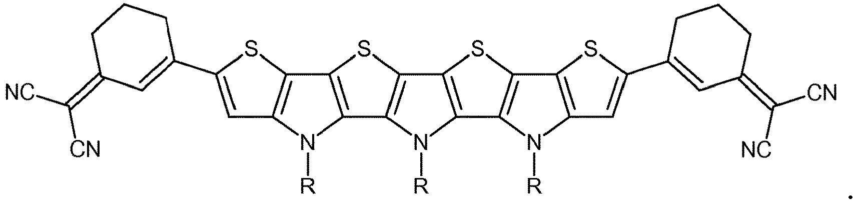

9. Bauelement nach einem der Ansprüche 1 bis 8, **dadurch gekennzeichnet, dass** mindestens eine dotierte Transportschicht vorhanden ist, die zwischen der Elektrode oder der Gegenelektrode und mindestens einer lichtabsorbierenden Schicht angeordnet ist.

10. Bauelement nach einem der Ansprüche 1 bis 9, **dadurch gekennzeichnet, dass** es sich um eine Einzelzelle, um eine Tandemzelle oder um eine Mehrfachzelle handelt.

11. Organische Solarzelle mit einem photoaktiven Bereich, der wenigstens ein organisches Donormaterial in Kontakt mit wenigstens einem organischen Akzeptormaterial aufweist, wobei das Donormaterial und das Akzeptormaterial einen Donor-Akzeptor-Heteroübergang ausbilden und wobei der photoaktive Bereich wenigstens eine Verbindung der Formel I, wie in Ansprüchen 1 bis 8 definiert, enthält.

## Claims

1. Optoelectronic component having an electrode (2) and a counterelectrode (6) and at least one organic light-sensitive layer (4) between the electrode (2) and the counterelectrode (6), **characterized in that** the organic light-sensitive layer (4) comprises a compound of the general formula I
EWG-Vₙ-D-Vₒ-EWG (I)
in which EWG has electron-withdrawing properties with respect to D,
V is -CR1=CR2- or -C≡C- with R1 and R2 selected from H, C1-C10-alkyl, C1-C10-Oalkyl, C1-C10-Salkyl, in which R1 and R2 may form a ring, and n and o are each independently 0 or 1, **characterized in that** D is an extended donor block formed from at least 5 fused aromatic heterocyclic 5-membered rings and/or heterocyclic or homocyclic 6-membered rings, with the proviso that the following structures are excluded: 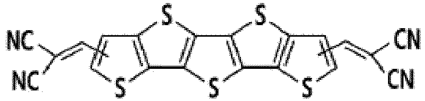 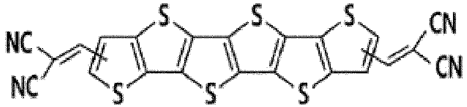 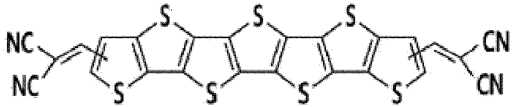 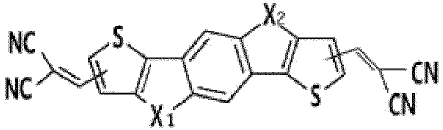 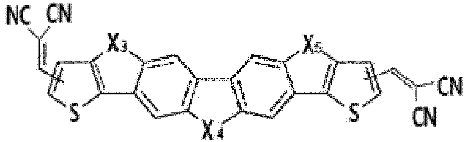 wherein X¹ to X⁵ are the same or different and are independently CR^{1'}R^{2'}, SiR³'R⁴', NR⁵', oxygen (O) or selenium (Se), wherein R^{1'} to R^{5'} are the same or different and are independently hydrogen, a substituted or unsubstituted C₁ to C₂₀ alkyl group, a substituted or unsubstituted C₆ to C₂₀ aryl group, a substituted or unsubstituted C₃ to C₂₀ heteroaryl group and combinations thereof.

2. Component according to Claim 1, **characterized in that** the extended donor block of the general formula I is formed from heterocyclic aromatic 5-membered rings selected from thiophene, selenophene, furan and pyrrole.

3. Component according to Claim 2, **characterized in that** at least one of the heterocyclic aromatic 5-membered rings is selected from selenophene, furan and pyrrole.

4. Component according to any one of Claims 1 to 3, **characterized in that** the extended donor block D of the general formula I is selected from 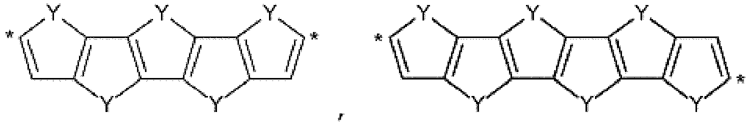 in which Y in each case is independently S or NR3 with R3 selected from C1-C10-alkyl, C5-C10-cycloalkyl, C6-C10-aryl.

5. Component according to any one of Claims 1 to 4, **characterized in that** the extended donor block D is formed of not more than seven fused aromatic heterocyclic 5-membered rings and/or aromatic heterocyclic or homocyclic 6-membered rings.

6. Component according to Claim 1, **characterized in that** the extended donor block D of the general formula I comprises one or two homocyclic aromatic 6-membered rings.

7. Component according to any one of Claims 1 to 6, **characterized in that** n and/or o is 1.

8. Component according to any one of Claims 1 to 4, wherein the compound of the organic light-sensitive layer is selected from the group of the following compounds:

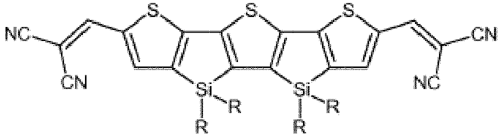

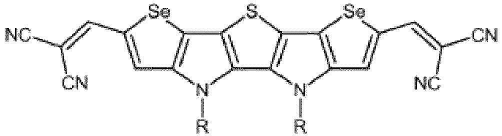

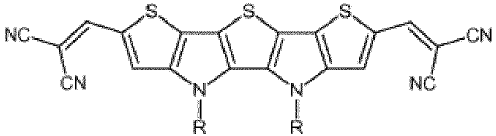

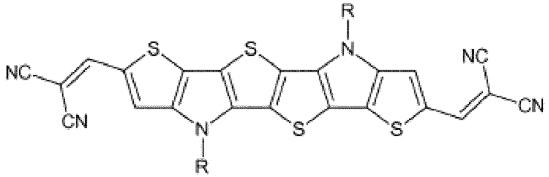

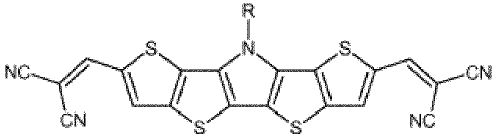

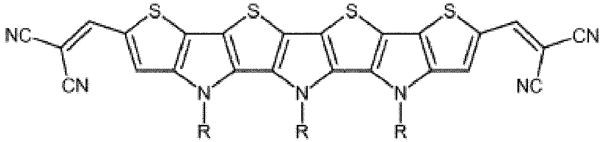

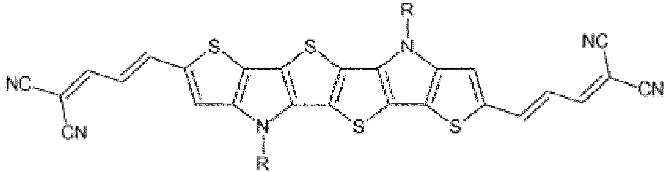

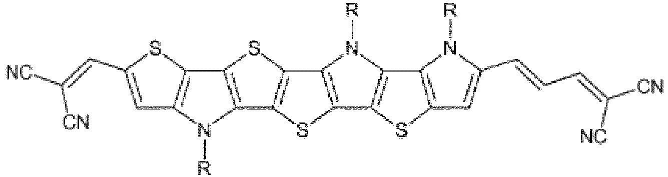

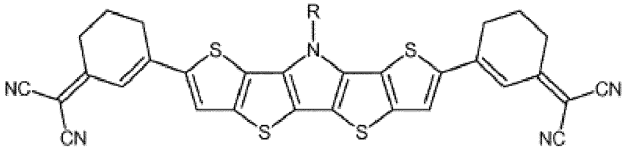

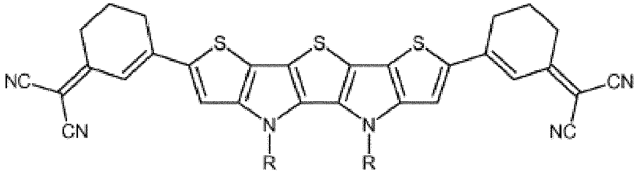

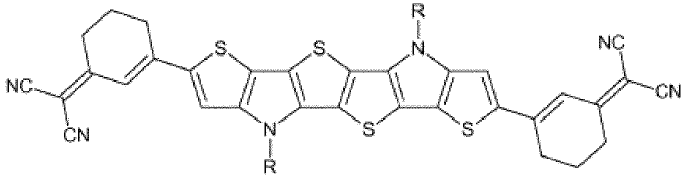

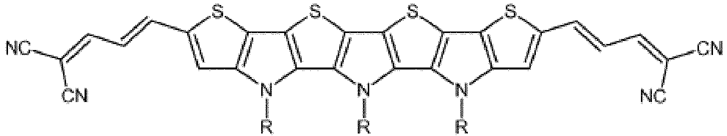

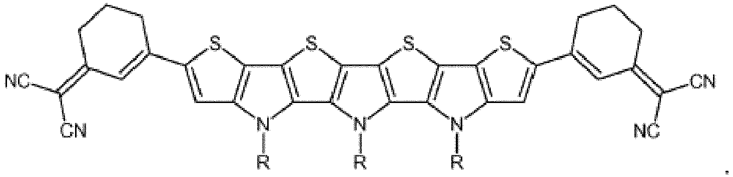

9. Component according to any one of Claims 1 to 8, **characterized in that** at least one doped transport layer is present, disposed between the electrode or counterelectrode and at least one light-absorbing layer.

10. Component according to any one of Claims 1 to 9, **characterized in that** the component is a single cell, a tandem cell or a multiple cell.

11. Organic solar cell having a photoactive region comprising at least one organic donor material in contact with at least one organic acceptor material, wherein the donor material and the acceptor material form a donor-acceptor heterojunction and wherein the photoactive region comprises at least one compound of the formula I as defined in Claims 1 to 8.

## Revendications

1. Composant optoélectronique comportant une électrode (2) et une contre-électrode (6) et au moins une couche photosensible organique (4) entre l'électrode (2) et la contre-électrode (6), **caractérisé en ce que** la couche photosensible organique (4) contient un composé de formule générale I
EWG-Vₙ-D-Vₒ-EWG (I)
dans laquelle EWG présente des propriétés électroattractrices vis-à-vis de D, V représente -CR1=CR2- ou -C=C-, R1 et R2 étant choisis parmi H, un alkyle en C1-C10, un OAlkyle en C1-C10, un SAlkyle en C1-C10, R1 et R2 pouvant former un cycle, et n et o représentent indépendamment l'un de l'autre 0 ou 1, **caractérisé en ce que** D est un bloc donneur élargi constitué d'au moins cinq cycles à 5 chaînons hétérocycliques aromatiques et/ou cycles à 6 chaînons hétérocycliques ou homocycliques condensés, à la condition d'exclure les structures suivantes: 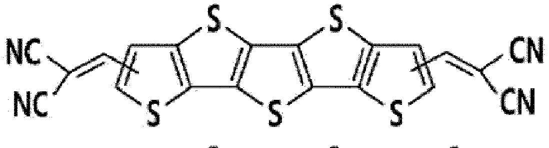 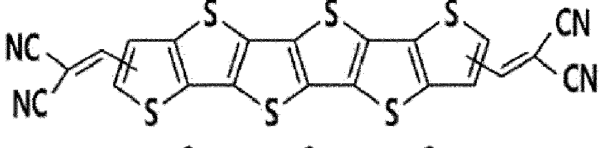 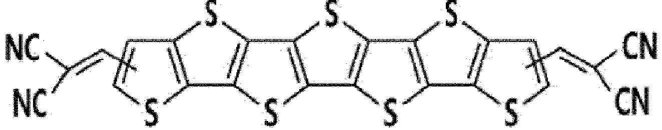 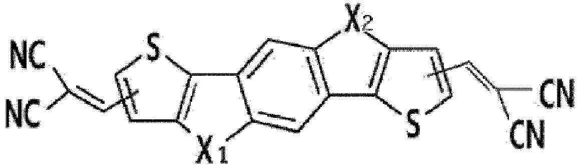 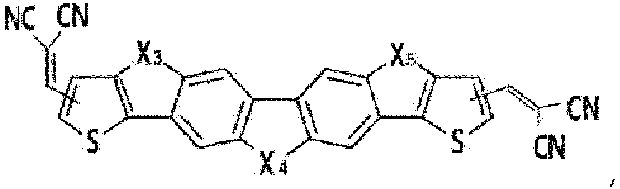 dans lesquels X¹ à X⁵ sont identiques ou différents et représentent chacun indépendamment des autres CR¹'CR²', SiR³'R⁴', NR⁵', un oxygène (O) ou un sélénium (Se), R¹' à R⁵' étant identiques ou différents et représentant indépendamment les uns des autres un hydrogène, un groupe alkyle en C₁ à C₂₀ substitué ou non substitué, un groupe aryle en C₆ à C₂₀ substitué ou non substitué, un groupe hétéroaryle en C₃ à C₂₀ substitué ou non substitué, et les combinaisons de ceux-ci.

2. Composant selon la revendication 1, **caractérisé en ce que** le bloc donneur élargi de formule générale I est constitué de cycles à 5 chaînons aromatiques hétérocycliques choisi parmi le thiophène, le sélénophène, le furanne ou le pyrrole.

3. Composant selon la revendication 2, **caractérisé en ce qu'**au moins l'un des cycles à 5 chaînons aromatiques hétérocycliques est choisi parmi un sélénophène, un furanne ou un pyrrole.

4. Composant selon l'une des revendications 1 à 3, **caractérisé en ce que** le bloc donneur élargi D de formule générale I est choisi parmi 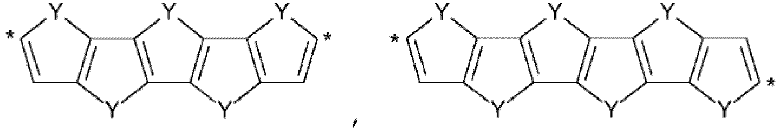 dans laquelle chaque Y représente indépendamment des autres S ou NR3, R3 étant choisi parmi un alkyle en C1-C10, un cycloalkyle en C5-C10, un aryle en C6-C10.

5. Composant selon l'une des revendication 1 à 4, **caractérisé en ce que** le bloc donneur élargi D est constitué au maximum de sept cycles à 5 chaînons hétérocycliques aromatiques et/ou de six cycles à 6 chaînons hétérocycliques ou homocycliques aromatiques, condensés.

6. Composant selon la revendication 1, **caractérisé en ce que** le bloc donneur élargi D de formule générale I comprend un ou deux cycles à 6 chaînons aromatiques homocycliques.

7. Composant selon l'une des revendications 1 à 6, **caractérisé en ce que** n et/ou o représentent 1.

8. Composant selon l'une des revendications 1 à 4, dans lequel le composé de la couche photosensible organique est choisi dans le groupe des composés suivants:

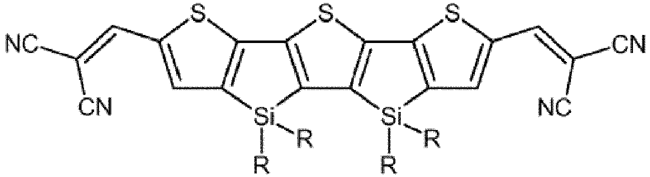

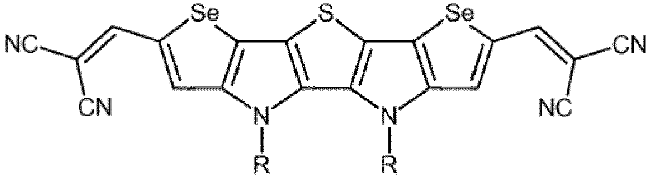

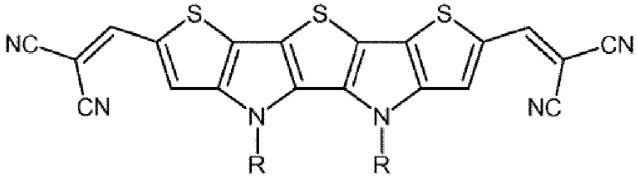

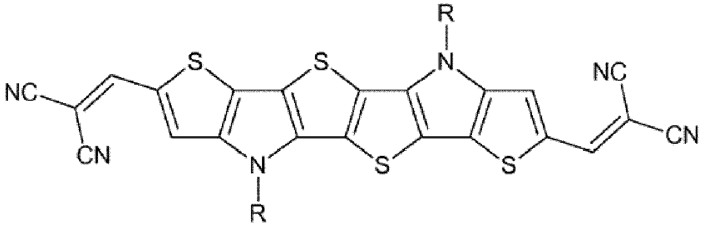

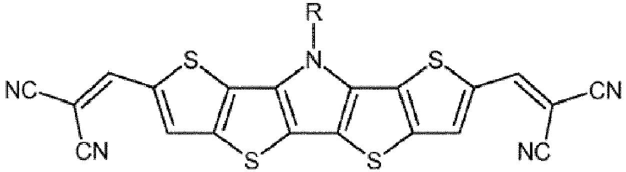

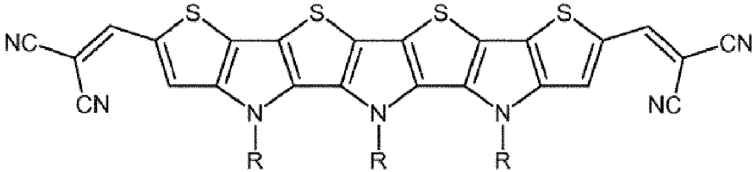

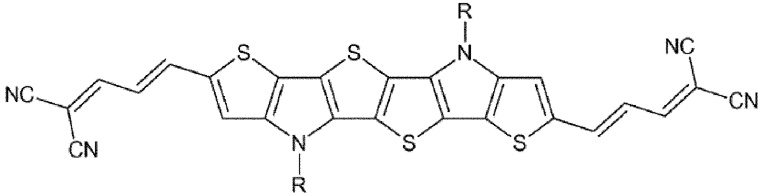

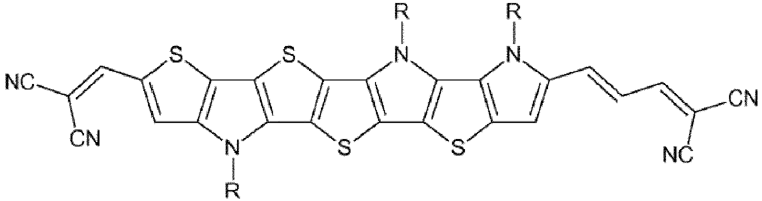

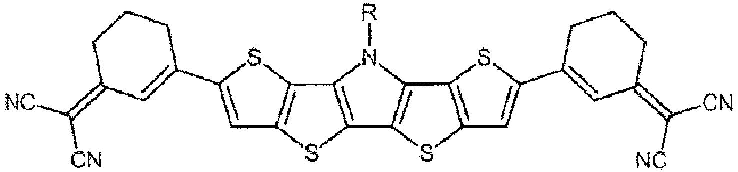

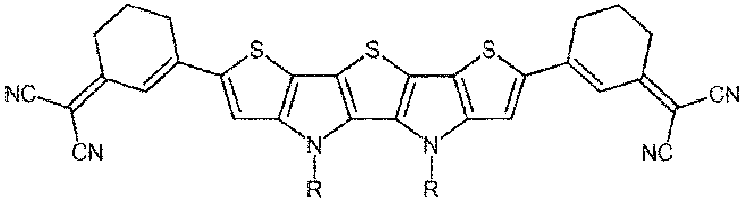

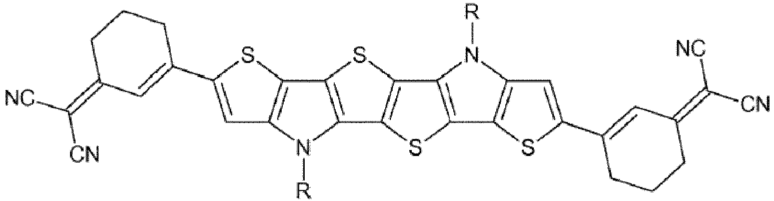

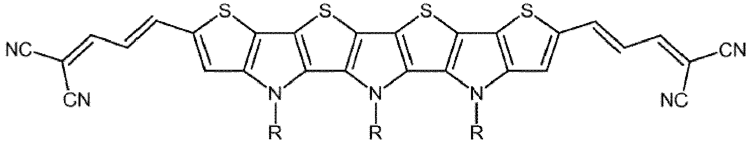

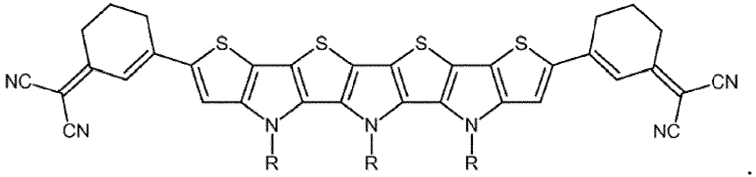

9. Composant selon l'une des revendications 1 à 8, **caractérisé en ce qu'**est présente au moins une couche de transport dopée, qui est disposée entre l'électrode ou la contre-électrode et au moins une couche photoabsorbante.

10. Composant selon l'une des revendications 1 à 9, **caractérisé en ce qu'**il s'agit d'une monocellule, une cellule tandem ou d'une multicellule.

11. Cellule solaire organique comportant une zone photoactive, qui présente au moins un matériau donneur organique en contact avec au moins un matériau accepteur organique, le matériau donneur et le matériau accepteur formant une hétérotransition donneur-accepteur, et la zone photoactive contenant au moins un composé de formule I tel que défini dans les revendications 1 à 8.
